# EUROPEAN PATENT APPLICATION

(11) **EP 4 615 190 A1**
(43) Date of publication of application: **10.09.2025**
(21) Application number: 25156704.6
(22) Date of filing: 07.02.2025
(51) Int. Cl.: H10B 12/00

(54) **SEMICONDUCTOR DEVICE**

(30) Priority: 08.03.2024 KR 20240033051
(71) Applicant: Samsung Electronics Co., Ltd., Suwon-si, Gyeonggi-do 16677 (KR)
(72) Inventor: JEONG, Moonyoung, 16677 Suwon-si (KR); LEE, Sangho, 16677 Suwon-si (KR); HAN, Joon, 16677 Suwon-si (KR)
(74) Representative: Marks & Clerk LLP

(57) **Abstract**

A semiconductor device includes a first structure including a memory region and a first peripheral circuit region; and a second structure overlapping the first structure vertically and including a core circuit region and a second peripheral circuit region, wherein the memory region includes a first cell vertical active pattern; a first word line having a side surface facing a first side surface of the first cell vertical active pattern; and a first cell gate dielectric layer between the first cell vertical active pattern and the first word line, wherein the first peripheral circuit region includes a first peripheral vertical active pattern disposed at substantially the same level as the first cell vertical active pattern; a first peripheral gate electrode having a side surface facing a first side surface of the first peripheral vertical active pattern; and a first peripheral gate dielectric layer between the first peripheral vertical active pattern and the first peripheral gate electrode.

## Description

### FIELD

Example embodiments of the present disclosure relate to a semiconductor device and a method of manufacturing the same.

### BACKGROUND

Research has been conducted to reduce the sizes of elements included in a semiconductor device and to improve performance thereof. For example, in a DRAM, research has been conducted to reliably and stably form elements having reduced sizes, but as sizes of the elements are reduced, performance of the semiconductor device has deteriorated.

### SUMMARY

An example embodiment of the present disclosure is to provide a semiconductor device which may increase integration density and may improve performance.

An example embodiment of the present disclosure is to provide a method of manufacturing the semiconductor device.

According to an example embodiment, a semiconductor device includes a first structure including a memory region and a first peripheral circuit region; and a second structure overlapping the first structure vertically and including a core circuit region and a second peripheral circuit region, wherein the memory region includes a first cell vertical active pattern; a first word line having a side surface facing a first side surface of the first cell vertical active pattern; and a first cell gate dielectric layer between the first cell vertical active pattern and the first word line, wherein the first peripheral circuit region includes a first peripheral vertical active pattern disposed at substantially the same level as the first cell vertical active pattern; a first peripheral gate electrode having a side surface facing a first side surface of the first peripheral vertical active pattern; and a first peripheral gate dielectric layer between the first peripheral vertical active pattern and the first peripheral gate electrode.

According to an example embodiment, a semiconductor device includes a first structure including a first memory region and a second memory region spaced apart from each other, and a first peripheral circuit region between the first memory region and the second memory region; and a second structure vertically overlapping and bonded to the first structure, wherein the second structure includes a first core circuit region vertically overlapping the first memory region; a second core circuit region vertically overlapping the second memory region; and a second peripheral circuit region vertically overlapping the first peripheral circuit region, wherein each of the first and second memory regions includes a cell transistor and a data storage structure electrically connected to the cell transistor, wherein the cell transistor includes a cell vertical active pattern; a word line having a side surface facing at least a portion of a side surface of the cell vertical active pattern; and a cell gate dielectric layer between the cell vertical active pattern and the word line.

According to an example embodiment, a semiconductor device includes a memory region including a cell transistor and data storage structure; a first peripheral circuit region disposed on an outside of the memory region and including the first peripheral circuit transistor; a core circuit region vertically overlapping the memory region and including a core circuit transistor; and a second peripheral circuit region disposed on an outside of the core circuit region, vertically overlapping the first peripheral circuit region, and including a second peripheral circuit transistor.

At least some of the above and other features of the invention are set out in the claims.

### BRIEF DESCRIPTION OF DRAWINGS

Various aspects, features, and advantages of example embodiments of the present disclosure will be more clearly understood from the following detailed description, taken in combination with the accompanying drawings, in which:
FIG. 1A is a diagram illustrating a semiconductor device according to an example embodiment of the present disclosure;
FIG. 1B is an enlarged diagram illustrating a portion of a semiconductor device according to an example embodiment of the present disclosure
FIG. 2A is an enlarged diagram illustrating a portion of a semiconductor device according to an example embodiment of the present disclosure;
FIG. 2B is an enlarged diagram illustrating a portion of a semiconductor device according to an example embodiment of the present disclosure;
FIGS. 3A, 3B, 3C, 3D, 3E, and 3F are enlarged cross-sectional diagrams illustrating a portion of a semiconductor device according to an example embodiment of the present disclosure;
FIGS. 4A, 4B, 4C and 4D are enlarged cross-sectional diagrams illustrating various examples of transistors in a semiconductor device according to an example embodiment of the present disclosure;
FIGS. 5A and 5B are plan diagrams illustrating various examples of transistors in a semiconductor device according to an example embodiment of the present disclosure;
FIGS. 6A and 6B are diagrams illustrating an inverter in a semiconductor device according to an example embodiment of the present disclosure;
FIG. 7 is an enlarged cross-sectional diagram illustrating an insulating structure of a semiconductor device according to an example embodiment of the present disclosure;
FIGS. 8A, 8B, 8C, 8D, 8E and 8F are plan diagrams illustrating various examples of a semiconductor device according to an example embodiment of the present disclosure;
FIG. 9A is a cross-sectional diagram illustrating a semiconductor device according to an example embodiment of the present disclosure;
FIG. 9B is a cross-sectional diagram illustrating a semiconductor device according to an example embodiment of the present disclosure;
FIG. 10 is a cross-sectional diagram illustrating a semiconductor device according to an example embodiment of the present disclosure;
FIG. 11 is a cross-sectional diagram illustrating a semiconductor device according to an example embodiment of the present disclosure;
FIG. 12 is a cross-sectional diagram illustrating a semiconductor device according to an example embodiment of the present disclosure;
FIG. 13 is a cross-sectional diagram illustrating a semiconductor device according to an example embodiment of the present disclosure;
FIG. 14 is a perspective diagram illustrating a semiconductor device according to an example embodiment of the present disclosure;
FIG. 15 is a flowchart illustrating a method of manufacturing a semiconductor device according to an example embodiment of the present disclosure; and
FIGS. 16A to 16H and 17 are cross-sectional diagrams illustrating a method of manufacturing a semiconductor device according to an example embodiment of the present disclosure.

### DETAILED DESCRIPTION

Hereinafter, example embodiments of the present disclosure will be described as follows with reference to the accompanying drawings. Hereinafter, terms such as "upper," "intermediate," "middle," "lower" and the like may be replaced with other terms, such as "first," "second," "third" and the like to describe the elements of the specification. Terms such as "first," "second" and "third" may be used to describe various elements, but the elements are not limited in order or relative position by the terms, and an element referred to as a "first element" may be equivalently referred to as a "second element." In the specification, terms such as 'lower', `upper', `upper end', and `lower end' may be terms that are described with reference to the drawings. A vertical length of the first element may refer to the distance from the lower surface to the upper surface of the first element.

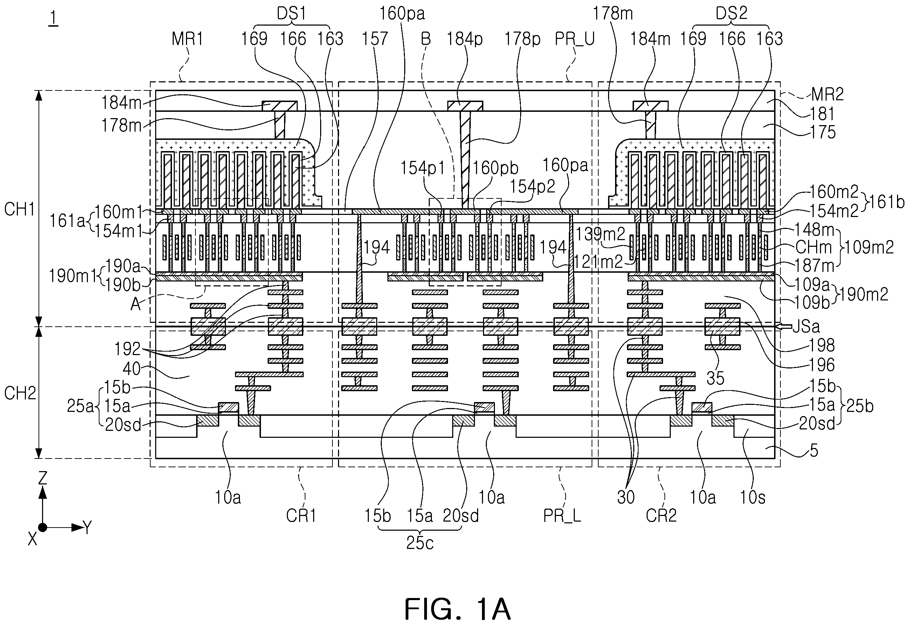

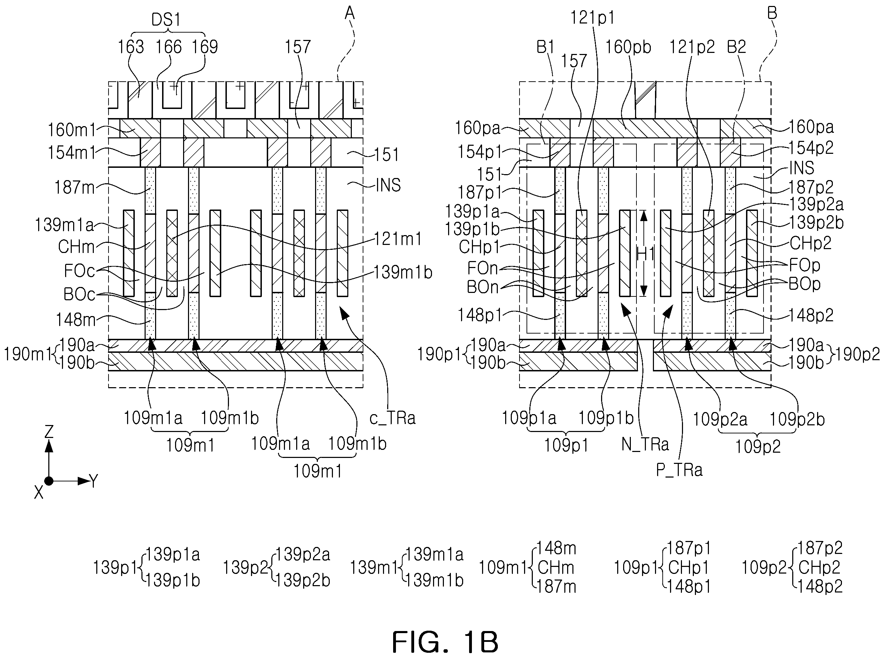

An example of a semiconductor device according to an example embodiment will be described with reference to FIGS. 1A and 1B. FIG. 1A is a cross-sectional diagram illustrating a semiconductor device according to an example embodiment, and FIG. 1B is an enlarged diagram illustrating regions "A" and "B" in FIG. 1A.

Referring to FIGS. 1A and 1B, a semiconductor device 1 according to an example embodiment may include a first structure CH1 and a second structure CH2 overlapping the first structure CH1 vertically. The first structure CH1 may be disposed on the second structure CH2. The first structure CH1 may be bonded to the second structure CH2.

The first structure CH1 may include a first memory region MR1 and a first peripheral circuit region PR_U disposed on an outside of the first memory region MR1.

The first structure CH1 may further include a second memory region MR2 disposed at the same level as a level of the first memory region MR1.

The first peripheral circuit region PR_U may be disposed between the first memory region MR1 and the second memory region MR2. The first memory region MR1 and the second memory region MR2 may have substantially the same structure.

Each of the first and second memory regions MR1 and MR2 may include cell transistors c_TRa and c_TRb. For example, the first memory region MR1 may include first cell transistors c_TRa, and the second memory region MR2 may include second cell transistors c_TRb. The cell transistors c_TRa and c_TRb may also be referred to as cell vertical channel transistors.

The first memory region MR1 may include cell vertical active patterns 109m1, word lines 139m1, and cell gate dielectric layers FOc between the cell vertical active patterns 109m1 and the word lines 139m1 included in the first cell transistors c_TRa.

The cell vertical active patterns 109m1 may include a first cell vertical active pattern 109m1a and a second cell vertical active pattern 109m1b adjacent to and spaced apart from each other.

The word lines 139m1 may include a first word line 139m1a having a side surface facing a first side surface of the first cell vertical active pattern 109m1a, and a second word line 139m1b having a side surface facing a second side surface of the second cell vertical active pattern 109m1b.

The cell gate dielectric layers FOc may be disposed between the first cell vertical active pattern 109m1a and the first word line 139m1a, and between the second cell vertical active pattern 109m1b and the second word line 139m1b.

The first memory region MR1 may further include cell back gate electrodes 121m1, and cell back gate dielectric layers BOc between the cell back gate electrodes 121m1 and the cell vertical active patterns 109m1. For example, the cell back gate electrode 121m1 may be disposed between the first cell vertical active pattern 109m1a and the second cell vertical active pattern 109m1b adjacent to each other, and the cell back gate dielectric layers BOc may be disposed between the first cell vertical active pattern 109m1a and the cell back gate electrode 121m1, and between the second cell vertical active pattern 109m1b and the cell back gate electrode 121m1.

The first word line 139m1a may have a side surface facing the first side surface of the first cell vertical active pattern 109m1a, the first word line 139m1b may have a side surface facing the second side surface of the second cell vertical active pattern 109m1b, and the cell back gate electrode 121m1 may be disposed between a third side surface of the first cell vertical active pattern 109m1a and a fourth side surface of the second cell vertical active pattern 109m1b, with the third side surface and the fourth side surface facing each other.

The first cell vertical active pattern 109m1a, the cell back gate electrode 121m1, and the second cell vertical active pattern 109m1b may be disposed between the first word line 139m1a and the second word line 139m1b.

Each of the cell vertical active patterns 109m1 may include a lower cell source/drain region 148m, an upper cell source/drain region 187m on the lower cell source/drain region 148m, and a cell channel region CHm between the lower cell source/drain region 148m and the upper cell source/drain region 187m.

The lower cell source/drain region 148m and the upper cell source/drain region 187m may have N-type conductivity.

The first word line 139m1a may have a side surface facing the cell channel region CHm of the first cell vertical active pattern 109m1a. The first word line 139m1b may have a side surface facing the cell channel region CHm of the second cell vertical active pattern 109m1b.

The second memory region MR2 and the first memory region MR1 may have substantially the same structure, such that the second memory region MR2 may include cell vertical active patterns 109m2, word lines 139m2 and cell back gate electrodes 121m2, corresponding to the cell vertical active patterns 109m1, the word lines 139m1 and the cell back gate electrodes 121m1 of the first memory region MR1, respectively.

The cell back gate electrodes 121m1 and 121m2 may control charges accumulated in the cell channel regions CHm of the cell vertical active patterns 109m1 and 109m2. Accordingly, the cell channel regions CHm may be configured as a floating body disposed between the lower and upper cell source/drain regions 148m and 187m, and the cell back gate electrodes 121m1 and 121m2 may prevent performance of the cell transistors c_TRa and c_TRb from being deteriorated due to the floating body effect and may improve performance of the cell transistors c_TRa and c_TRb. Accordingly, the cell back gate electrodes 121m1 and 121m2 may prevent charges, for example, holes from being accumulated in the floating body of the cell channel regions CHm and changing a threshold voltage of the cell transistors c_TRa and c_TRb during operation of the cell transistors c_TRa and c_TRb. Accordingly, the cell back gate electrodes 121m1 and 121m2 may allow the cell transistors c_TRa and c_TRb to operate stably, and performance of the semiconductor device 1 may be improved.

The first peripheral circuit region PR_U may include the first peripheral circuit transistors N_TRa and P_TRa disposed at substantially the same level as the cell transistors c_TRa and c_TRb. For example, the first peripheral circuit region PR_U may include first peripheral NMOS transistors N_TRa and first peripheral PMOS transistors P_PRa.

The first peripheral circuit region PR_U may include peripheral gate electrodes 139p1 and 139p2, peripheral vertical active patterns 109p1 and 109p2, and peripheral gate dielectric layers FOn and FOp included in the first peripheral circuit transistors N_TRa and P_TRa. The peripheral vertical active patterns 109p1 and 109p2 may include NMOS vertical active patterns 109p1 and PMOS vertical active patterns 109p2.

The cell vertical active patterns 109m1 and 109m2 and the peripheral vertical active patterns 109p1 and 109p2 may include a material used as a channel of a transistor, for example, a semiconductor material. For example, each of the cell vertical active patterns 109m1 and 109m2 and the peripheral vertical active patterns 109p1 and 109p2 may include at least one of a silicon layer, oxide semiconductor layer, and two-dimensional material layer having semiconductor properties, which may be used as a channel region. For example, each of the cell vertical active patterns 109m1 and 109m2 and the peripheral vertical active patterns 109p1 and 109p2 may include single crystal silicon or polysilicon.

The peripheral gate electrodes 139p1 and 139p2 may include NMOS gate electrodes 139p1 and PMOS gate electrodes 139p2. The peripheral gate dielectric layers FOn and FOp may include NMOS gate dielectric layers FOn and PMOS gate dielectric layers FOp.

The word lines 139m1 and 139m2, the NMOS gate electrodes 139p1, and the PMOS gate electrodes 139p2 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof, but an example embodiment thereof is not limited thereto. Each of the word lines 139m1 and 139m2, the NMOS gate electrodes 139p 1, and the PMOS gate electrodes 139p2 may include a single layer or multiple layers formed of the aforementioned conductive materials. In an example embodiment, the NMOS gate electrodes 139p1 and the PMOS gate electrodes 139p2 may include conductive materials having different work functions.

The NMOS vertical active patterns 109p1 may include a first NMOS vertical active pattern 109p1a and a second NMOS vertical active pattern 109p1b adjacent to and spaced apart from each other.

In an example, a spacing distance between the cell vertical active patterns 109m1 adjacent to each other with the cell back gate electrode 121m1 therebetween may be substantially the same as a spacing distance between the first NMOS vertical active pattern 109p1a and the second NMOS vertical active pattern 109p1b adjacent to each other.

The NMOS gate electrodes 139p1 may have a first NMOS gate electrode 139p1a having a side surface facing the first side surface of the first NMOS vertical active pattern 109p1a, and a second NMOS gate electrode 139p1b having a side surface facing the second side surface of the second NMOS vertical active pattern 109p1b.

The NMOS gate dielectric layers FOn may be disposed between the first NMOS vertical active pattern 109p1a and the first NMOS gate electrode 139p1a, and between the second NMOS vertical active pattern 109p1b and the second NMOS gate electrode 139p1b.

The PMOS vertical active patterns 109p2 may include a first PMOS vertical active pattern 109p2a and a second PMOS vertical active pattern 109p2b adjacent to and spaced apart from each other.

In an example, a spacing distance between the cell vertical active patterns 109m1 adjacent to each other with the cell back gate electrode 121m1 therebetween may be substantially the same as a spacing distance between the first PMOS vertical active pattern 109p2a and the second PMOS vertical active pattern 109p2b adjacent to each other.

The PMOS gate electrodes 139p2 may have a first PMOS gate electrode 139p2a having a side surface facing the first side surface of the first PMOS vertical active pattern 109p2a, and a second PMOS gate electrode 139p2b having a side surface facing the second side surface of the second PMOS vertical active pattern 109p2b.

The PMOS gate dielectric layers FOp may be disposed between the first PMOS vertical active pattern 109p2a and the first PMOS gate electrode 139p2a, and between the second PMOS vertical active pattern 109p2b and the second PMOS gate electrode 139p2b.

The NMOS gate electrodes 139p1 may have a vertical length H1 substantially the same as that of the word lines 139m1 and 139m2.

The PMOS gate electrodes 139p2 may have a vertical length H1 substantially the same as that of the word lines 139m1 and 139m2.

The first peripheral circuit region PR_U may further include third peripheral gate electrodes 121p1 and 121p2 and third peripheral gate dielectric layers BOn and BOp.

The third peripheral gate electrodes 121p1 and 121p2 may be configured as peripheral back gate electrodes. Similarly to the cell back gate electrodes 121m1 and 121m2, the third peripheral gate electrodes 121p1 and 121p2, which may be peripheral back gate electrodes, may enable the peripheral circuit transistors N_TRa and P_TR to operate stably, such that performance of the semiconductor device 1 may be improved.

The cell back gate electrodes 121m1 and 121m2 and the third peripheral gate electrodes 121p1 and 121p2 may include at least one conductive material. For example, each of the cell back gate electrodes 121m1 and 121m2 and the third peripheral gate electrodes 121p1 and 121p2 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof, but an example embodiment thereof is not limited thereto. Each of the cell back gate electrodes 121m1 and 121m2 and the third peripheral gate electrodes 121p1 and 121p2 may include a single layer or multiple layers formed of the aforementioned materials.

In an example, the cell back gate electrodes 121m1 and 121m2 and the third peripheral gate electrodes 121p1 and 121p2 may include a material different from that of the word lines 139m1 and 139m2.

In another example, the cell back gate electrodes 121m1 and 121m2 and the third peripheral gate electrodes 121p1 and 121p2 may include the same material as that of the word lines 139m1 and 139m2.

In an example, the cell back gate electrodes 121m1 and 121m2 and the third peripheral gate electrodes 121p1 and 121p2 may have the same vertical length.

In an example, the vertical length of the cell back gate electrodes 121m1 and 121m2 and the third peripheral gate electrodes 121p1 and 121p2 may be different from the vertical length of the word lines 139m1 and 139m2 and the peripheral gate electrodes 139p1 and 139p2, respectively.

In another example, the vertical length of the cell back gate electrodes 121m1 and 121m2 and the third peripheral gate electrodes 121p1 and 121p2 may be the same as the vertical length of the word lines 139m1 and 139m2 and the peripheral gate electrodes 139p1 and 139p2, respectively.

The third peripheral gate electrodes 121p1 and 121p2 may include a third NMOS gate electrode 121p1 disposed between the first NMOS vertical active pattern 109p1a and the second NMOS vertical active pattern 109p1b, adjacent to each other, and a third PMOS gate electrode 121p2 disposed between the first PMOS vertical active pattern 109p2a and the second PMOS vertical active pattern 109p2b, adjacent to each other.

The third peripheral gate dielectric layers BOn and BOp may include third NMOS gate dielectric layers BOn and third PMOS gate dielectric layers BOp.

The third NMOS gate dielectric layers BOn may be disposed between the first NMOS vertical active pattern 109p1a and the third NMOS gate electrode 121p1, and between the second NMOS vertical active pattern 109p1b and the third NMOS gate electrode 121p1.

The third PMOS gate dielectric layers BOp may be disposed between the first PMOS vertical active pattern 109p2a and the third PMOS gate electrode 121p2, and between the second PMOS vertical active pattern 109p2b and the third PMOS gate electrode 121p2.

The first NMOS gate electrode 139p1a may have a side surface facing the first side surface of the first NMOS vertical active pattern 109p1a, the second NMOS gate electrode 139p1b may have a side surface facing the second side surface of the second NMOS vertical active pattern 109p1b, and the third NMOS gate electrode 121p1 may be disposed between the third side surface of the first NMOS vertical active pattern 109p1a and the fourth side surface of the second NMOS vertical active pattern 109p1b, with the third side surface and the fourth side surface facing each other.

The first NMOS vertical active pattern 109p1a, the third NMOS gate electrode 121p1, and the second NMOS vertical active pattern 109p1b may be disposed between the first NMOS gate electrode 139p1a and the second NMOS gate electrode 139p1b.

In an example embodiment, the third NMOS gate electrode 121p1 may be configured as an NMOS back gate electrode.

The first PMOS gate electrode 139p2a may have a side surface facing the first side surface of the first PMOS vertical active pattern 109p2a, the second PMOS gate electrode 139p2b may have a side surface facing the second side surface of the second PMOS vertical active pattern 109p2b, and the third PMOS gate electrode 121p2 may be disposed between the third side surface of the first PMOS vertical active pattern 109p2a and the fourth side surface of the second PMOS vertical active pattern 109p2b, with the third side surface and the fourth side surface facing each other.

The first PMOS vertical active pattern 109p2a, the third PMOS gate electrode 121p2, and the second PMOS vertical active pattern 109p2b may be disposed between the first PMOS gate electrode 139p2a and the second PMOS gate electrode 139p2b.

In an example embodiment, the third PMOS gate electrode 121p2 may be configured as a PMOS back gate electrode.

Each of the NMOS vertical active patterns 109p1 may include a lower NMOS source/drain region 148p1, an upper NMOS source/drain region 187p1 on the lower NMOS source/drain region 148p1, and an NMOS channel region CHp1 between the lower NMOS source/drain region 148p1 and the upper NMOS source/drain region 187p1.

The lower NMOS source/drain region 148p1 and the upper NMOS source/drain region 187p1 may have N-type conductivity.

In an example, the lower NMOS source/drain region 148p1 and the upper NMOS source/drain region 187p1 may have an impurity concentration substantially the same as those of the lower cell source/drain region 148m and the upper cell source/drain region 187m.

In another example, the lower NMOS source/drain region 148p1 and the upper NMOS source/drain region 187p1 may have an impurity concentration higher than impurity concentrations of the lower cell source/drain region 148m and the upper cell source/drain region 187m.

Each of the PMOS vertical active patterns 109p2 may include a lower PMOS source/drain region 148p2, an upper PMOS source/drain region 187p2 on the lower PMOS source/drain region 148p2, and a PMOS channel region CHp2 between the lower PMOS source/drain region 148p2 and the upper PMOS source/drain region 187p2.

The lower PMOS source/drain region 148p2 and the upper PMOS source/drain region 187p2 may have P-type conductivity.

The first NMOS gate electrode 139p1a may have a side surface facing the NMOS channel region CHp1 of the first NMOS vertical active pattern 109p1a. The second NMOS gate electrode 109p1b may have a side surface facing the NMOS channel region CHp1 of the second NMOS vertical active pattern 109p1b.

The first PMOS gate electrode 139p2a may have a side surface facing the PMOS channel region CHp2 of the first PMOS vertical active pattern 109p2a. The second PMOS gate electrode 139p2b may have a side surface facing the PMOS channel region CHp2 of the second PMOS vertical active pattern 109p2b.

Each of the first and second memory regions MR1 and MR2 may further include data storage structures DS1 and DS2.

The data storage structures DS1 and DS2 may be disposed on the cell transistors c_TRa and c_TRb. The data storage structures DS1 and DS2 may be electrically connected to the cell transistors c_TRa and c_TRb. The data storage structures DS1 and DS2 may include the first data storage structure DS1 in the first memory region MR1 and the second data storage structure DS2 in the second memory region MR2.

The data storage structures DS1 and DS2 may be configured as memory cell capacitors which may store data in a memory such as a DRAM, but an example embodiment thereof is not limited thereto. For example, the data storage structures DS1 and DS2 may be configured as a data storage structure of MRAM or a data storage structure of FeRAM.

Each of the data storage structures DS1 and DS2 may include first electrodes 163 extending in the vertical direction Z, a second electrode 169 on a side surface and an upper surface of each of the first electrodes 163, and a dielectric layer 166 between the first electrodes 163 and the second electrode 169.

Each of the first and second memory regions MR1 and MR2 may further include cell contact structures 161a and 161b between the cell transistors c_TRa and c_TRb and the data storage structures DS1 and DS2. The cell contact structures 161a and 161b may be disposed on the cell transistors c_TRa and c_TRb. The cell contact structures 161a and 161b may be electrically connected to the upper cell source/drain regions 187m of the cell transistors c_TRa and c_TRb.

The cell contact structures 161a and 161b may include a first cell contact structures 161a which may electrically connect the first cell transistors c_TRa to the first data storage structure DS1 in the first memory region MR1, and a second cell contact structures 161b which may electrically connect the second cell transistors c_TRb to the second data storage structure DS2 in the second memory region MR2.

Each of the first and second cell contact structures 161a and 161b may include a cell plug pattern 154m1, 154m2, and a cell pad pattern 160m1, 160m2 on the cell plug pattern 154m1, 154m2. A vertical central axis of the cell pad pattern 160m1, 160m2 may not be aligned with a vertical central axis of the cell plug pattern 154m1, 154m2.

The cell plug patterns 154m1, 154m2 may be connected to the upper cell source/drain regions 187m. The cell pad patterns 160m1, 160m2 may be connected to the first electrodes 163.

The first peripheral circuit region PR_U may further include a peripheral vertical active patterns 109p1 and 109p2 on the peripheral contact structures 154p1 and 154p2 and a peripheral contact structures 154p1 and 154p2 on the upper peripheral wirings 160pa and 160pb.

The peripheral contact structures 154p1 and 154p2 may be disposed at substantially the same level as the cell plug patterns 154m1. The peripheral contact structures 154p1 and 154p2 and the cell plug patterns 154m1 may include the same conductive material.

The peripheral contact structures 154p1 and 154p2 may include NMOS contact structures 154p1 electrically connected to the upper NMOS source/drain regions 187p1 and PMOS contact structures 154p2 electrically connected to the upper PMOS source/drain regions 187p2.

The upper peripheral wirings 160pa and 160pb may be disposed at substantially the same level as the cell pad patterns 160m1. The upper peripheral wirings 160pa and 160pb and the cell pad patterns 160m1 may include the same conductive material.

The upper peripheral wirings 160pa and 160pb may include first upper peripheral wirings 160pa and second upper peripheral wirings 160pb.

The first memory region MR1 may further include a first bit line 190m1 below the cell transistors c_TRa, and the second memory region MR2 may further include a second bit line 190m2 below the cell transistors c_TRb.

The first bit line 190m1 may be connected to the lower cell source/drain regions 148m of the cell vertical active patterns 109m1 in the first memory region MR1, and the second bit line 190m2 may be connected to the lower cell source/drain regions 148m of the cell vertical active patterns 109m2 in the second memory region MR2.

The first peripheral circuit region PR_U may further include lower peripheral wirings 190p1 and 190p2 disposed at substantially the same level as the first and second bit lines 190m1 and 190m2 and disposed below the peripheral circuit transistors N_TRa and P_TRa.

The lower peripheral wirings 190p1 and 190p2 may include a first lower peripheral wiring 190p1 connected to the NMOS vertical active patterns 109p1 and a second lower peripheral wiring 190p2 connected to the PMOS vertical active patterns 109p2.

Each of the bit lines 190m1 and 190m2 and the lower peripheral wirings 190p1 and 190p2 may include at least one conductive material layer. For example, each of the bit lines 190m1 and 190m2 and the lower peripheral wirings 190p1 and 190p2 may include doped polysilicon, metal, conductive metal nitride, metal-semiconductor compound, conductive metal oxide, conductive graphene, and carbon nanotube or a combination thereof. For example, each of the bit lines 190m1 and 190m2 and the lower peripheral wirings 190p1 and 190p2 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, graphene, carbon nanotube, or a combination thereof, but an example embodiment thereof is not limited thereto. Each of the bit lines 190m1 and 190m2 and the lower peripheral wirings 190p1 and 190p2 may include a single layer or multiple layers formed of the aforementioned conductive materials. For example, each of the bit lines 190m1 and 190m2 and the lower peripheral wirings 190p1 and 190p2 may include a first conductive layer 190a and a second conductive layer 190b below the first conductive layer 190a.

The first conductive layer 190a of the first lower peripheral wiring 190p1 may include polysilicon having N-type conductivity, and the first conductive layer 190a of the second lower peripheral wiring 190p2 may include polysilicon having P-type conductivity.

The first structure CH1 may further include a first routing wiring structure 192 disposed on a level lower than levels of the bit lines 190m1 and 190m2 and the lower peripheral wirings 190p1 and 190p2, and first bonding pads 196 disposed on a level lower than a level of the first routing wiring structure 192.

The first routing wiring structure 192 may include a plurality of wirings disposed on different levels and a plurality of vias connected to an upper surface and a lower surface of the plurality of wirings, respectively.

The first routing wiring structure 192 may be electrically connected to the bit lines 190m1 and 190m2. In example embodiments, the first routing wiring structure 192 may be electrically connected to the lower peripheral wirings 190p1 and 190p2.

The first structure CH1 may further include connection contact plugs 194 disposed between the first routing wiring structure 192 and the first upper peripheral wirings 160pa and electrically connecting the first routing wiring structure 192 to the first upper peripheral wirings 160pa.

The connection contact plugs 194 may be in contact with lower surfaces of the first upper peripheral wirings 160pa, may extend downwardly and may be connected to one of the plurality of wirings of the first routing wiring structure 192.

The first structure CH1 may include first, second, third, fourth, and fifth insulating structures 198, INS, 151, 157, and 175.

The first insulating structure 198 may have a lower surface coplanar with the lower surfaces of the first bonding pads 196, and may have an upper surface coplanar with upper surfaces of the bit lines 190m1 and 190m2 and the lower peripheral wirings 190p1 and 190p2. The first insulating structure 198 may include a plurality of insulating layers.

The second insulating structure INS may have a lower surface coplanar with lower surfaces of the cell vertical active patterns 109m1 and 109m2, the NMOS vertical active patterns 109p1, and the PMOS vertical active patterns 109p2, and an upper surface coplanar with upper surfaces of the cell vertical active patterns 109m1 and 109m2, the NMOS vertical active patterns 109p1, and the PMOS vertical active patterns 109p2. The second insulating structure INS may include a plurality of insulating layers.

The third insulating structure 151 may be disposed on side surfaces of the cell plug patterns 154m1 and the peripheral contact structures 154p1 and 154p2.

The fourth insulating structure 157 may be disposed on side surfaces of the cell pad patterns of 160m1 and the upper peripheral wirings of 160pa and 160pb.

The fifth insulating structure 175 may be disposed on the data storage structures DS1 and DS2 and the upper peripheral wirings 160pa and 160pb.

The first structure CH1 may further include cell contact plugs 178m on the second electrodes 169 of the data storage structures DS1 and DS2 and peripheral contact plug 178p on the second upper peripheral wiring 160pb.

The cell contact plugs 178m may penetrate the fifth insulating structure 175 and may be electrically connected to the second electrodes 169 of the data storage structures DS1 and DS2.

The peripheral contact plug 178p may penetrate the fifth insulating structure 175 and may be electrically connected to the second upper peripheral wiring 160pb.

The first structure CH1 may further include the cell upper wirings 184m on the cell contact plugs 178m and the third peripheral upper wiring 184p on the peripheral contact plug 178p. The cell upper wirings 184m and the third peripheral upper wiring 184p may be disposed on substantially the same level.

The first structure CH1 may further include an upper insulating structure 181 on the fifth insulating structure 175, the cell upper wirings 184m, and the third peripheral upper wiring 184p.

The second structure CH2 may include a first core circuit region CR1 vertically overlapping the first memory region MR1 and a second peripheral circuit region PR_L vertically overlapping the first peripheral circuit region PR_U.

The second structure CH2 may further include a second core circuit region CR2 vertically overlapping the second memory region MR2. The second peripheral circuit region PR_L may be disposed between the first core circuit region CR1 and the second core circuit region CR2.

The second structure CH2 may include a substrate 5 and a device isolation region 10s limiting active regions 10a on the substrate 5. The substrate 5 may be configured as a semiconductor substrate.

The second structure CH2 may further include lower peripheral circuit transistors 25a, 25b, and 25c disposed on the substrate 5, a second routing wiring structure 30 electrically connected to the lower peripheral circuit transistors 25a, 25b, and 25c on the lower peripheral circuit transistors 25a, 25b, and 25c, second bonding pads 35 electrically connected to the second routing wiring structure 30 on the second routing wiring structure 30, and a lower insulating structure 40.

Each of the lower peripheral circuit transistors 25a, 25b, and 25c may include peripheral gate structures 15a and 15b disposed on the active region 10a, and peripheral source/drain regions 20sd disposed in the active region 10a disposed on both sides of the peripheral gate structure 15a and 15b. The peripheral gate structures 15a and 15b may include peripheral gate dielectric layer 15a and peripheral gate electrode 15b stacked in order.

The lower peripheral circuit transistors 25a, 25b, and 25c may include a first core circuit transistor 25a in the first core circuit region CR1, a second core circuit transistor 25b in the second core circuit region CR2, and a second peripheral circuit transistor 25c in the second peripheral circuit region PR_L.

The first core circuit region CR1 may include the first core circuit transistor 25a. The first core circuit transistor 25a may be electrically connected to the first bit line 190m1 through the second routing wiring structure 30, the second bonding pad 35, the first bonding pad 196 and the first routing wiring structure 192.

The second core circuit region CR2 may include the second core circuit transistor 25b. The second core circuit transistor 25b may be electrically connected to the second bit line 190m2 through the second routing wiring structure 30, the second bonding pad 35, the first bonding pad 196 and the first routing wiring structure 192.

The first core circuit transistor 25a may vertically overlap the first data storage structure DS1, and the second core circuit transistor 25b may vertically overlap the second data storage structure DS2.

The first peripheral circuit region PR_U and the second peripheral circuit region PR_L may not vertically overlap the first and second data storage structures DS1 and DS2.

The lower insulating structure 40 may be disposed on the substrate 5 and may have an upper surface coplanar with upper surfaces of the second bonding pads 35.

Upper surfaces of the second bonding pads 35 may be bonded to lower surfaces of the first bonding pads 196, and upper surfaces of the lower insulating structure 40 may be bonded to lower surfaces of the first insulating structure 198. Accordingly, a bonding surface JSa may be formed between the first structure CH1 and the second structure CH2.

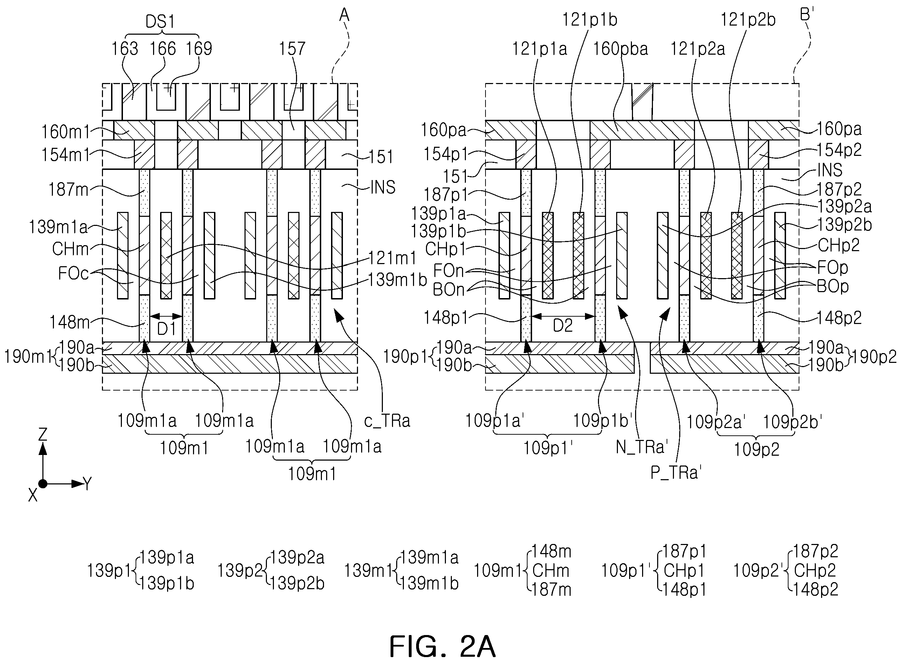

In the description below, an example of a semiconductor device according to an example embodiment will be described with reference to FIG. 2A. FIG. 2A is an enlarged diagram illustrating region A of FIG. 1B and further illustrating region B' that may replace the region B in FIG. 1B.

Referring to the region A, the cell vertical active patterns 109m1 described above, adjacent to each other with the cell back gate electrode 121m1 therebetween, may be spaced apart each other from with a first distance D1.

In an example, the first NMOS vertical active pattern (109p1a in FIG. 1B) and the second NMOS vertical active pattern (109p1b in FIG. 1B) described above, adjacent to each other, may be replaced with a first NMOS vertical active pattern 109p1a' and a second NMOS vertical active pattern 109p1b' spaced apart from each other with a second distance D2. The second distance D2 may be different from the first distance D1. The second distance D2 may be greater than the first distance D1.

In an example, the first PMOS vertical active pattern (109p2a in FIG. 1B) and the second PMOS vertical active pattern (109p2b in FIG. 1B) described above, adjacent to each other, may be replaced with a first PMOS vertical active pattern 109p2a' and a second PMOS vertical active pattern 109p2b' spaced apart from each other with the second distance D2.

In an example, the third NMOS gate electrode (121p1 in FIG. 1B) described above, disposed between the first NMOS vertical active pattern (109p1a in FIG. 1B) and the second NMOS vertical active pattern (109p1b in FIG. 1B) adjacent to each other may be replaced with a third NMOS gate electrode 121p1a and a fourth NMOS gate electrode 121p1b spaced apart from each other between the first NMOS vertical active pattern 109p1a' and the second NMOS vertical active pattern 109p1b'.

In an example, the third and fourth NMOS gate electrodes 121p1a and 121p1b may be the peripheral back gate electrode described above.

In an example, the same bias as that of the first and second NMOS gate electrodes 139p1a and 139p1b may be applied to the third and fourth NMOS gate electrodes 121p1a and 121p1b. Accordingly, first NMOS transistors N_TRa' using the third and fourth NMOS gate electrodes 121p1a and 121p1b and the first and second NMOS gate electrodes 139p1a and 139p1b as NMOS gate electrodes may be provided. For example, the first NMOS transistor N_TRa' may include the first NMOS gate electrode 139p1a and the third NMOS gate electrode 121p1a applied with the same bias to work as an NMOS gate electrode on both sides of the first NMOS vertical active pattern 109p1a.

In an example, the third PMOS gate electrode (121p2 in FIG. 1B) described above, disposed between the first PMOS vertical active pattern (109p2a in FIG. 1B) and the second PMOS vertical active pattern (109p2b in FIG. 1B) adjacent to each other may be replaced with a third PMOS gate electrode 121p2a and a fourth PMOS gate electrode 121p2b spaced apart from each other between the first PMOS vertical active pattern 109p2a' and the second PMOS vertical active pattern 109p2b'.

In an example, the third and fourth PMOS gate electrodes 121p2a and 121p2b may be the peripheral back gate electrodes described above.

In an example, the same bias as the first and second PMOS gate electrodes 139p2a and 139p2b may be applied to the third and fourth PMOS gate electrodes 121p2a and 121p2b. Accordingly, the first PMOS transistors P_TRa' using the third and fourth PMOS gate electrodes 121p2a and 121p2b and the first and second PMOS gate electrodes 139p2a and 139p2b as PMOS gate electrodes may be provided. For example, the first PMOS transistor P TRa' may include the first PMOS gate electrode 139p2a and the third PMOS gate electrode 121p2a applied with the same bias to work as a PMOS gate electrode on both sides of the first PMOS vertical active pattern 109p2a.

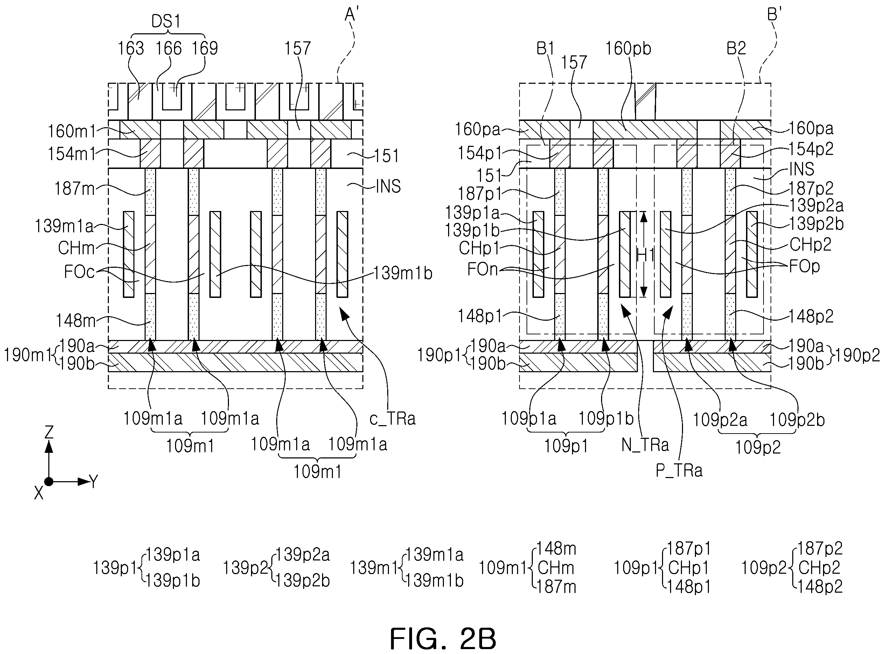

In the description below, an example of a semiconductor device according to an example embodiment will be described with reference to regions A' and B" in FIG. 2B. The regions A' and B" are enlarged diagrams illustrating regions that may replace regions "A" and "B" in FIGS. 1A and 1B.

Referring to A' and B", the cell back gate electrode 121m1 and the cell back gate dielectric layer BOc described with reference to FIGS. 1A and 1B may not be provided. The third NMOS gate electrode 121p1, the third NMOS gate dielectric layer BOn, the third PMOS gate electrode 121p2, and the third PMOS gate dielectric layer BOp described with reference to FIGS. 1A and 1B may not be provided.

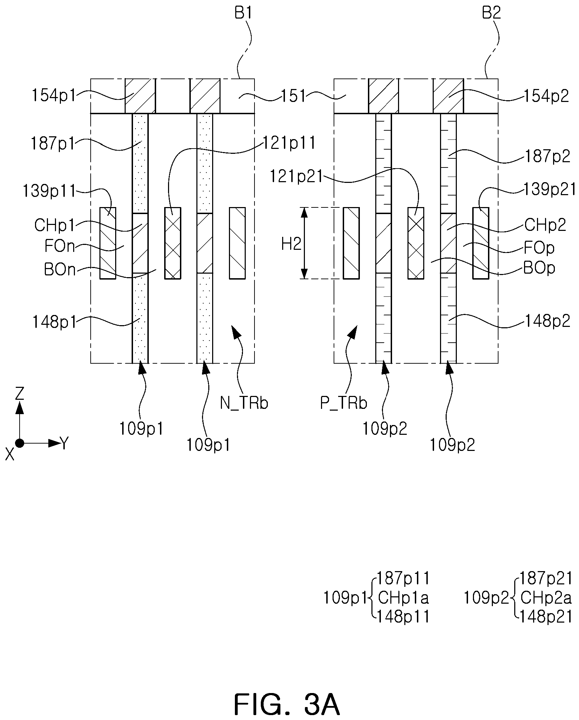

In the description below, example embodiments of various types of first peripheral circuit transistors or peripheral contact plugs included in the first peripheral circuit region PR_U described above will be described with reference to FIGS. 3A to 3F. In FIGS. 3A to 3F, region B1 may correspond to region B1 in FIG. 1B, and region B2 may correspond to region B2 in FIG. 1B. For example, in FIGS. 3A to 3F, region B 1 may be a region in which a peripheral NMOS transistor is disposed, and region B2 may be a region in which a peripheral PMOS transistor is disposed. In FIGS. 3A to 3F, the same reference numeral as in FIG. 1B may indicate an element having the same form as described in FIG. 1B. Accordingly, in FIGS. 3A to 3F, the elements modified or replaced with different shapes from the elements in FIG. 1B will be described.

In an example, referring to FIG. 3A, a peripheral NMOS gate electrode 139p11 having a vertical length H2 smaller than the vertical length H1 of the word lines (139m1 in FIG. 1B) may be provided. A peripheral PMOS gate electrode 139p21 having a vertical length H2 smaller than the vertical length H1 of the word lines (139m1 in FIG. 1B) may be provided. A third NMOS gate electrode 121p11 having a vertical length H2 smaller than the vertical length H1 of the word lines (139m1 in FIG. 1B) may be provided. A third PMOS gate electrode 121p21 having a vertical length H2 smaller than the vertical length H1 of the word lines (139m1 in FIG. 1B) may be provided.

A second peripheral NMOS transistor N_TRb including a peripheral NMOS gate electrode 139p11 having a vertical length smaller than that of the first peripheral NMOS transistor N_TRa in FIG. 1B may be provided. A second peripheral PMOS transistor P_TRb including a peripheral PMOS gate electrode 139p21 having a reduced vertical length smaller than that of the first peripheral PMOS transistor P_TRa in FIG. 1B may be provided.

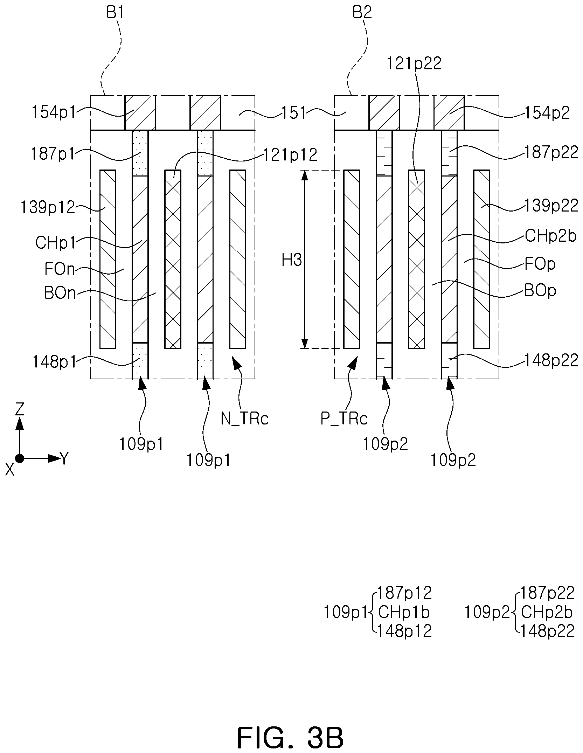

In an example, referring to FIG. 3B, a peripheral NMOS gate electrode 139p12 having a vertical length H3 greater than the vertical length H1 of the word lines (139m1 in FIG. 1B) may be provided. A peripheral PMOS gate electrode 139p22 having a vertical length H3 greater than the vertical length H1 of the word lines (139m1 in FIG. 1B) may be provided. A third NMOS gate electrode 121p12 having a vertical length H3 greater than the vertical length H1 of the word lines (139m1 in FIG. 1B) may be provided. A third PMOS gate electrode 121p22 having a vertical length H3 greater than the vertical length H1 of the word lines (139m1 in FIG. 1B) may be provided.

A third peripheral NMOS transistor N_TRc including a peripheral NMOS gate electrode 139p 12 having a vertical length greater than that of the first peripheral NMOS transistor N_TRa in FIG. 1B may be provided. A third peripheral PMOS transistor P_TRc including a peripheral PMOS gate electrode 139p22 having a vertical length greater than that of the first peripheral PMOS transistor P_TRa in FIG. 1B may be provided.

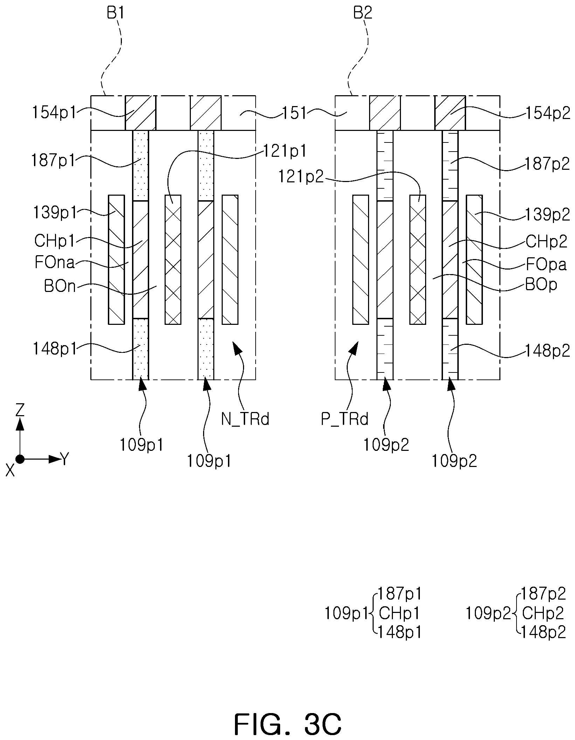

In an example, referring to FIG. 3C, an NMOS gate dielectric layer FOna having a thickness smaller than that of the NMOS gate dielectric layer (FOn in FIG. 1B) in FIG. 1B may be provided. A PMOS gate dielectric layer FOpa having a thickness smaller than that of the PMOS gate dielectric layer in FIG. 2A (FOp in FIG. 1B) may be provided.

A fourth peripheral NMOS transistor N_TRd including the NMOS gate dielectric layer FOna having a thickness smaller than that of the first peripheral NMOS transistor N_TRa in FIG. 1B may be provided. A fourth peripheral PMOS transistor P_TRd including the PMOS gate dielectric layer FOpa having a thickness smaller than that of the first peripheral PMOS transistor P_TRa in FIG. 1B may be provided.

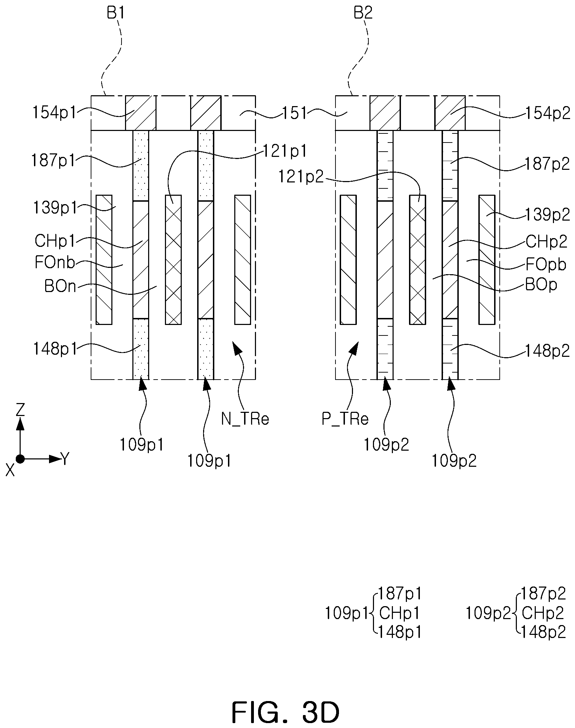

In an example, referring to FIG. 3D, an NMOS gate dielectric layer FOnb having a thickness greater than that of the NMOS gate dielectric layer (FOn in FIG. 1B) in FIG. 1B may be provided. A PMOS gate dielectric layer FOpb having a thickness greater than that of the PMOS gate dielectric layer (FOp in FIG. 1B) in FIG. 1B may be provided.

A fifth peripheral NMOS transistor N_TRe including the NMOS gate dielectric layer FOnb a thickness greater than that of the first peripheral NMOS transistor N_TRa in FIG. 1B may be provided. A fifth peripheral PMOS transistor P_TRe including the PMOS gate dielectric layer FOpb having a thickness greater than the first peripheral PMOS transistor P_TRa in FIG. 1B may be provided.

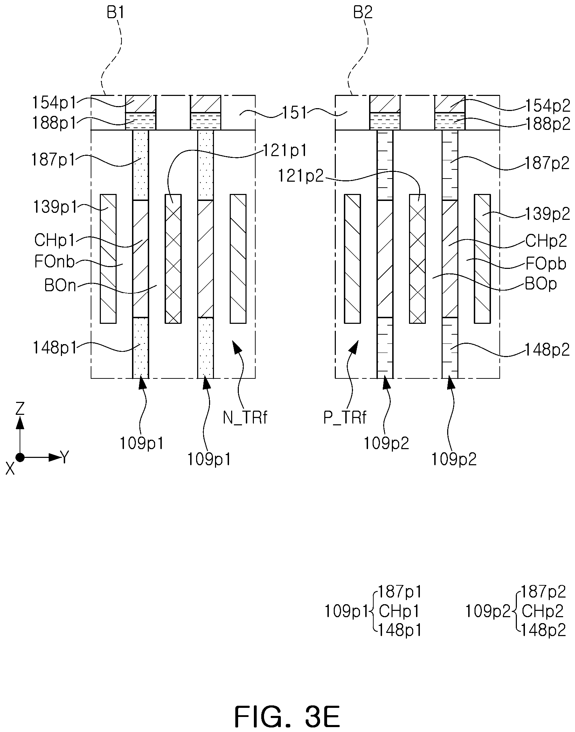

In an example, referring to FIG. 3E, an additional NMOS source/drain region 188p1 may be disposed on the upper NMOS source/drain region 187p1 as in FIG. 1B. An additional PMOS source/drain region 188p2 may be disposed on the upper PMOS source/drain region 187p2 as illustrated in FIG. 1B.

The additional NMOS source/drain region 188p1 may have an upper surface in contact with a lower surface of the peripheral NMOS contact structure 154p1. The additional PMOS source/drain region 188p2 may have an upper surface in contact with a lower surface of the peripheral PMOS contact structure 154p2.

The additional NMOS source/drain region 188p1 may be formed of silicon having N-type conductivity, and the additional PMOS source/drain region 188p2 may be formed of silicon having P-type conductivity. The additional NMOS source/drain region 188p1 may be formed of polysilicon having N-type conductivity or epitaxial silicon having N-type conductivity. The additional PMOS source/drain region 188p2 may be formed of polysilicon having P-type conductivity or epitaxial silicon having P-type conductivity.

A sixth peripheral NMOS transistor N_TRf including the additional NMOS source/drain region 188p1 may be provided rather than the first peripheral NMOS transistor N_TRa as illustrated in FIG. 1B. A sixth peripheral PMOS transistor P_TRf including the additional PMOS source/drain region 188p2 may be provided rather than the first peripheral PMOS transistor P_TRa as illustrated in FIG. 1B.

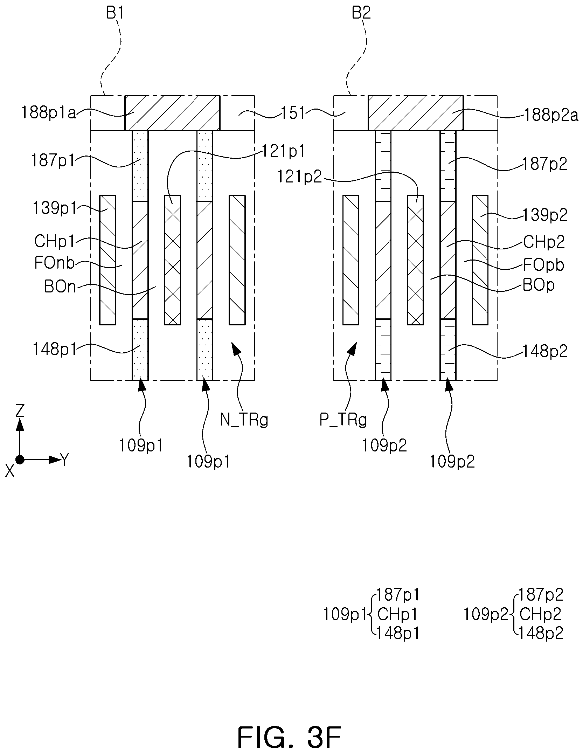

In an example, referring to FIG. 3F, the additional NMOS source/drain region 188p1 as in FIG. 3E may be replaced with a merged NMOS source/drain region 188p1a connected to the NMOS vertical active patterns 109p1 adjacent to each other. The additional PMOS source/drain region 188p2 as illustrated in FIG. 3E may be replaced with a merged PMOS source/drain region 188p2a connected to the PMOS vertical active patterns 109p2 adjacent to each other.

The merged NMOS source/drain region 188p1a may vertically overlap the third NMOS gate electrode 121p1. The merged PMOS source/drain region 188p2a may vertically overlap the third PMOS gate electrode 121p2.

The merged NMOS source/drain region 188p1a may be formed of silicon having N-type conductivity, and the merged PMOS source/drain region 188p2a may be formed of silicon having P-type conductivity. The merged NMOS source/drain region 188p1a may be formed of polysilicon having N-type conductivity or epitaxial silicon having N-type conductivity. The merged PMOS source/drain region 188p2a may be formed of polysilicon having P-type conductivity or epitaxial silicon having P-type conductivity.

A seventh peripheral NMOS transistor N_TRg further including the merged NMOS source/drain region 188p1a rather than the first peripheral NMOS transistor N_TRa as illustrated in FIG. 1B may be provided. A seventh peripheral PMOS transistor P_TRg further including the merged PMOS source/drain region 188p2a rather than the first peripheral PMOS transistor P_TRa as illustrated in FIG. 1B may be provided.

In FIGS. 1A to 3F described above, the first peripheral circuit region PR_U may include at least one of the first to seventh peripheral NMOS transistors N_TRa, N_TRb, N_TRc, N_TRd, N_TRe, N_TRf, and N_TRg, and may include at least one of the first to seventh peripheral PMOS transistors P_TRa, P TRb, P_TRc, P_TRd, P_TRe, P_TRf, and P_TRg. Accordingly, the first peripheral circuit region PR_U may form various peripheral circuits using the first to seventh peripheral NMOS transistors N_TRa, N_TRb, N_TRc, N_TRd, N_TRe, N_TRf, and N_TRg and the first to seventh peripheral PMOS transistors P_TRa, P_TRb, P_TRc, P_TRd, P_TRe, P_TRf, and P_TRg.

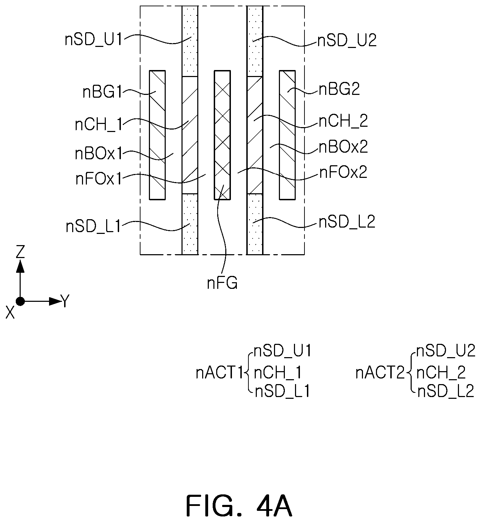

In the description below, example embodiments of various circuits having cross-sectional structures using the first to seventh peripheral NMOS transistors N_TRa, N_TRb, N_TRc, N_TRd, N_TRe, N_TRf, N_TRg, the first to seventh peripheral PMOS transistors P_TRa, P TRb, P_TRc, P TRd, P_TRe, P_TRf, and P_TRg, the third peripheral NMOS gate electrode 121p1 and the third peripheral PMOS gate electrode 121p2 in the first peripheral circuit region PR_U will be described with reference to FIGS. 4A to 4D. FIGS. 4A to 4D are enlarged diagrams illustrating various examples included in a circuit in a semiconductor device according to an example embodiment.

In an example, referring to FIG. 4A, the first NMOS vertical active pattern nACT1 and the second NMOS vertical active pattern nACT2 may be disposed adjacent to each other. The first NMOS vertical active pattern nACT1 may include a first lower NMOS source/drain region nSD_L1, a first upper NMOS source/drain region nSD_U1 on the first lower NMOS source/drain region nSD L1, and a first NMOS channel region nCH_1 between the first lower NMOS source/drain region nSD_L1 and the first upper NMOS source/drain region nSD_U1. The second NMOS vertical active pattern nACT2 may include a second lower NMOS source/drain region nSD_L2, a second upper NMOS source/drain region nSD_U2 on the second lower NMOS source/drain region nSD _L2, and a second NMOS channel region nCH_2 between the second lower NMOS source/drain region nSD_L2 and the second upper NMOS source/drain region nSD_U2.

The first NMOS vertical active pattern nACT1 and the second NMOS vertical active pattern nACT2 may be substantially the same as the NMOS vertical active patterns 109p1 as illustrated in FIG. 1B.

The NMOS gate electrode nFG may be disposed between the first NMOS channel region nCH_1 of the first NMOS vertical active pattern nACT1 and the second NMOS channel region nCH_2 of the second NMOS vertical active pattern nACT2.

The first NMOS gate dielectric layer nFOx1 may be disposed between the first NMOS vertical active pattern nACT1 and the NMOS gate electrode nFG, and the second NMOS gate dielectric layer nFOx2 may be disposed between the second NMOS vertical active pattern nACT2 and the NMOS gate electrode nFG.

The first NMOS back gate electrode nBG1 and the second NMOS back gate electrode nBG2 may be disposed opposite each other. The first NMOS channel region nCH_1, the NMOS gate electrode nFG, and the second NMOS channel region nCH_2 may be disposed between the first NMOS back gate electrode nBG1 and the second NMOS back gate electrode nBG2.

The first NMOS back gate dielectric layer nBOx1 may be disposed between the first NMOS back gate electrode nBG1 and the first NMOS vertical active pattern nACT1, and the second NMOS back gate dielectric layer nBOx2 may be disposed between the second NMOS back gate electrode nBG2 and the second NMOS vertical active pattern nACT2.

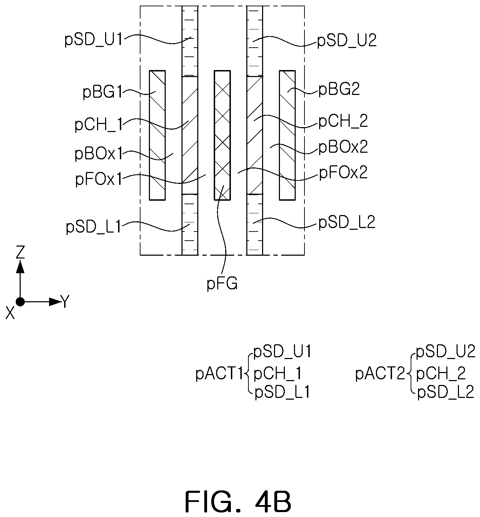

In an example, referring to FIG. 4B, the first PMOS vertical active pattern pACT1 and the second PMOS vertical active pattern pACT2 may be disposed adjacent to each other. The first PMOS vertical active pattern pACT1 may include a first lower PMOS source/drain region pSD L1, a first upper PMOS source/drain region pSD_U1 on the first lower PMOS source/drain region pSD L1, and a first PMOS channel region pCH_1 between the first lower PMOS source/drain region pSD_L1 and the first upper PMOS source/drain region pSD_U1. The second PMOS vertical active pattern pACT2 may include a second lower PMOS source/drain region pSD_L2, a second upper PMOS source/drain region pSD_U2 on the second lower PMOS source/drain region pSD _L2, and a second PMOS channel region pCH_2 between the second lower PMOS source/drain region pSD_L2 and the second upper PMOS source/drain region pSD_U2.

The first PMOS vertical active pattern pACT1 and the second PMOS vertical active pattern pACT2 may be substantially the same as the PMOS vertical active patterns 109p2 as illustrated in FIG. 1B.

The PMOS gate electrode pFG may be disposed between the first PMOS channel region pCH_1 of the first PMOS vertical active pattern pACT1 and the second PMOS channel region pCH_2 of the second PMOS vertical active pattern pACT2.

The first PMOS gate dielectric layer pFOx1 may be disposed between the first PMOS vertical active pattern pACT1 and the PMOS gate electrode pFG, and the second PMOS gate dielectric layer pFOx2 may be disposed between the second PMOS vertical active pattern pACT2 and the PMOS gate electrode pFG.

The first PMOS back gate electrode pBG1 and the second PMOS back gate electrode pBG2 may be disposed opposite each other. The first PMOS channel region pCH_1, the PMOS gate electrode pFG, and the second PMOS channel region pCH_2 may be disposed between the first PMOS back gate electrode pBG1 and the second PMOS back gate electrode pBG2.

The first PMOS back gate dielectric layer pBOx1 may be disposed between the first PMOS back gate electrode pBG1 and the first PMOS vertical active pattern pACT1, and the second PMOS back gate dielectric layer pBOx2 may be disposed between the second PMOS back gate electrode pBG2 and the second PMOS vertical active pattern pACT2.

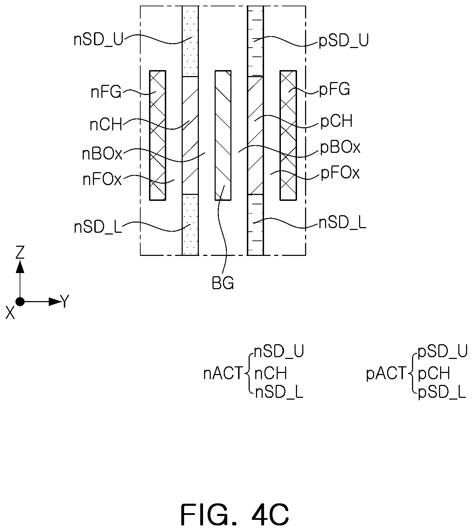

In an example, referring to FIG. 4C, an NMOS vertical active pattern nACT and a PMOS vertical active pattern pACT may be disposed adjacent to each other. The NMOS vertical active pattern nACT may include a lower NMOS source/drain region nSD L, an upper NMOS source/drain region nSD_U on the lower NMOS source/drain region nSD_L, and an NMOS channel region nCH between the lower NMOS source/drain region nSD_L and the upper NMOS source/drain region nSD_U. The PMOS vertical active pattern pACT may include a lower PMOS source/drain region pSD L, an upper PMOS source/drain region pSD_U on the lower PMOS source/drain region pSD L, and a PMOS channel region pCH between the lower PMOS source/drain region pSD_L and the upper PMOS source/drain region pSD_U.

A shared back gate electrode BG may be disposed between the NMOS channel region nCH of the NMOS vertical active pattern nACT and the PMOS channel region pCH of the PMOS vertical active pattern pACT.

The NMOS back gate dielectric layer nBOx may be disposed between the NMOS vertical active pattern nACT and the shared back gate electrode BG, and the PMOS back gate dielectric layer pBOx may be disposed between the PMOS vertical active pattern pACT and the shared back gate electrode BG.

An NMOS gate electrode nFG and a PMOS gate electrode pFG may be disposed opposite each other. The NMOS channel region nCH, the shared back gate electrode BG, and the PMOS channel region pCH may be disposed between the NMOS gate electrode nFG and the PMOS gate electrode pFG.

The NMOS gate dielectric layer nFOx may be disposed between the NMOS gate electrode nFG and the NMOS vertical active pattern nACT, and the PMOS gate dielectric layer pFOx may be disposed between the PMOS gate electrode pFG and the PMOS vertical active pattern pACT.

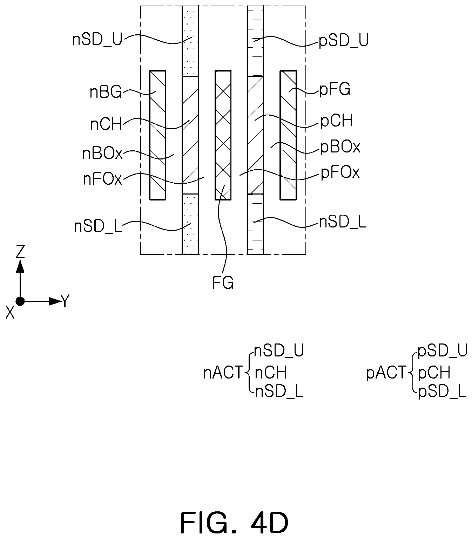

In an example, referring to FIG. 4D, the NMOS vertical active pattern nACT and the PMOS vertical active pattern pACT may be disposed adjacent to each other as in FIG. 4C.

The shared gate electrode FG may be disposed between the NMOS channel region nCH of the NMOS vertical active pattern nACT and the PMOS channel region pCH of the PMOS vertical active pattern pACT.

The NMOS gate dielectric layer nFOx may be disposed between the NMOS vertical active pattern nACT and the shared gate electrode FG, and the PMOS gate dielectric layer pFOx may be disposed between the PMOS vertical active pattern pACT and the shared gate electrode FG.

An NMOS back gate electrode nBG and a PMOS back gate electrode pBG may be disposed opposite each other. The NMOS channel region nCH, the shared gate electrode FG, and the PMOS channel region pCH may be disposed between the NMOS back gate electrode nBG and the PMOS back gate electrode pBG.

The NMOS back gate dielectric layer nBOx may be disposed between the NMOS back gate electrode nBG and the NMOS vertical active pattern nACT, and the PMOS back gate dielectric layer pBOx may be disposed between the PMOS back gate electrode pBG and the PMOS vertical active pattern pACT.

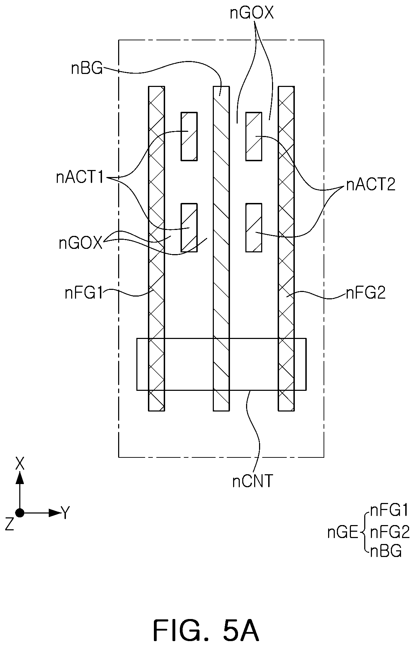

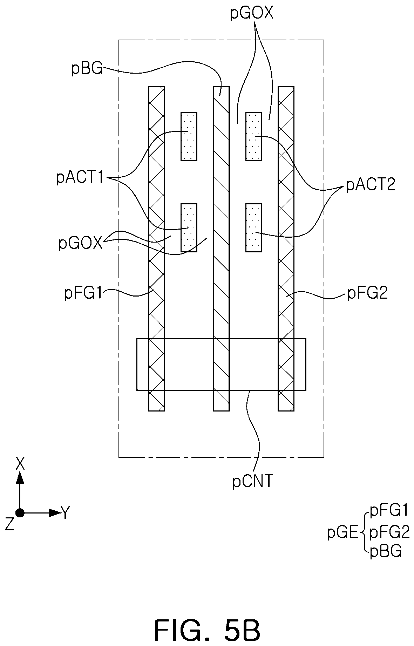

In the description below, example embodiments of planar shapes of various circuits which may be formed using the first to seventh peripheral NMOS transistors N_TRa, N TRb, N TRc, N TRd, N TRe, N TRf, and N TRg, the first to seventh peripheral PMOS transistors P_TRa, P TRb, P_TRc, P_TRd, P_TRe, P_TRf, and P_TRg, the third peripheral NMOS gate electrode 121p1 and the third peripheral PMOS gate electrode 121p2 in the first peripheral circuit region PR_U will be described with reference to FIGS. 5A and 5B. FIGS. 5A and 5B are plan diagrams illustrating various examples included in a circuit in a semiconductor device according to an example embodiment.

In an example, referring to FIG. 5A, a first NMOS vertical active pattern nACT1 and a second NMOS vertical active pattern nACT2 may be disposed adjacent to each other in the second horizontal direction Y.

A plurality of the first NMOS vertical active pattern nACT1 may be arranged in order in the first horizontal direction X. A plurality of the second NMOS vertical active pattern nACT2 may be arranged in order in the first horizontal direction.

The first NMOS vertical active pattern nACT1 and the second NMOS vertical active pattern nACT2 may be substantially the same as the NMOS vertical active patterns 109p1 as in FIG. 1B.

The back gate electrode nBG may be disposed between the first NMOS vertical active pattern nACT1 and the second NMOS vertical active pattern nACT2. The back gate electrode nBG may be substantially the same as the third peripheral NMOS gate electrode 121p1 as in FIG. 1B.

The first NMOS gate electrode nFG1 and the second NMOS gate electrode nFG2 may be disposed opposite each other. The first NMOS vertical active pattern nACT1, the second NMOS vertical active pattern nACT2, and the back gate electrode nBG may be disposed between the first NMOS gate electrode nFG1 and the second NMOS gate electrode nFG2.

The routing wiring structure nCNT may be electrically connected to each of the back gate electrode nBG, the first NMOS gate electrode nFG1 and the second NMOS gate electrode nFG2. The routing wiring structure nCNT may operate the back gate electrode nBG, the first NMOS gate electrode nFG1 and the second NMOS gate electrode nFG2 as a gate electrode. Accordingly, an NMOS transistor using the back gate electrode nBG, the first NMOS gate electrode nFG1 and the second NMOS gate electrode nFG2 as a gate electrode may be provided.

In an example, referring to FIG. 5B, the first PMOS vertical active pattern pACT1 and the second PMOS vertical active pattern pACT2 may be disposed adjacent to each other in the second horizontal direction Y.

A plurality of the first PMOS vertical active pattern pACT1 may be arranged in order in the first horizontal direction X. A plurality of the second PMOS vertical active pattern pACT2 may be arranged in order in the first horizontal direction X.

The first PMOS vertical active pattern pACT1 and the second PMOS vertical active pattern pACT2 may be substantially the same as the PMOS vertical active patterns 109p1 as in FIG. 1B.

The back gate electrode pBG may be disposed between the first PMOS vertical active pattern pACT1 and the second PMOS vertical active pattern pACT2. The back gate electrode pBG may be substantially the same as the third peripheral PMOS gate electrode 121p2 as in FIG. 1B.

The first PMOS gate electrode pFG1 and the second PMOS gate electrode pFG2 may be disposed opposite each other. The first PMOS vertical active pattern pACT1, the second PMOS vertical active pattern pACT2, and the back gate electrode pBG may be disposed between the first PMOS gate electrode pFG1 and the second PMOS gate electrode pFG2.

The routing wiring structure pCNT may be electrically connected to each of the back gate electrode pBG, the first PMOS gate electrode pFG1 and the second PMOS gate electrode pFG2. The routing wiring structure pCNT may operate the back gate electrode pBG, the first PMOS gate electrode pFG1 and the second PMOS gate electrode pFG2 as a gate electrode. Accordingly, a PMOS transistor using the back gate electrode pBG, the first PMOS gate electrode pFG1 and the second PMOS gate electrode pFG2 as a gate electrode may be provided.

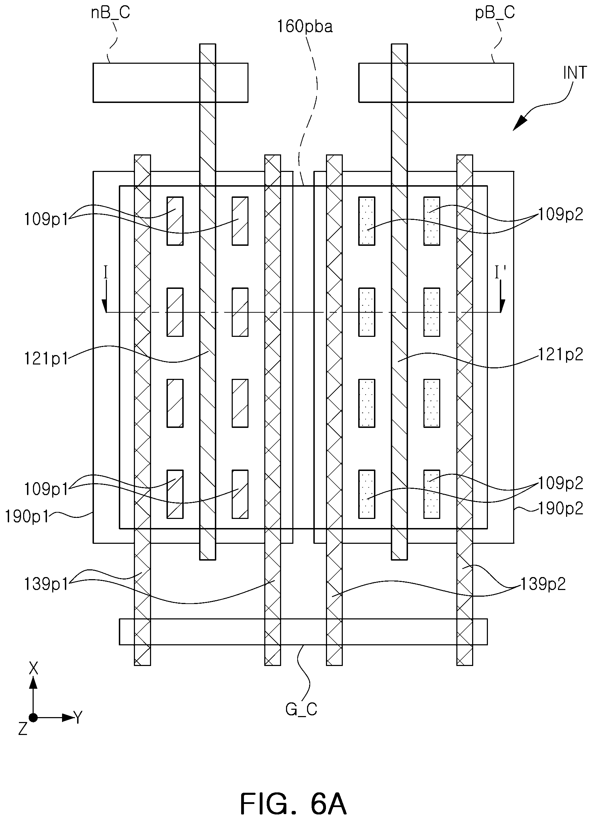

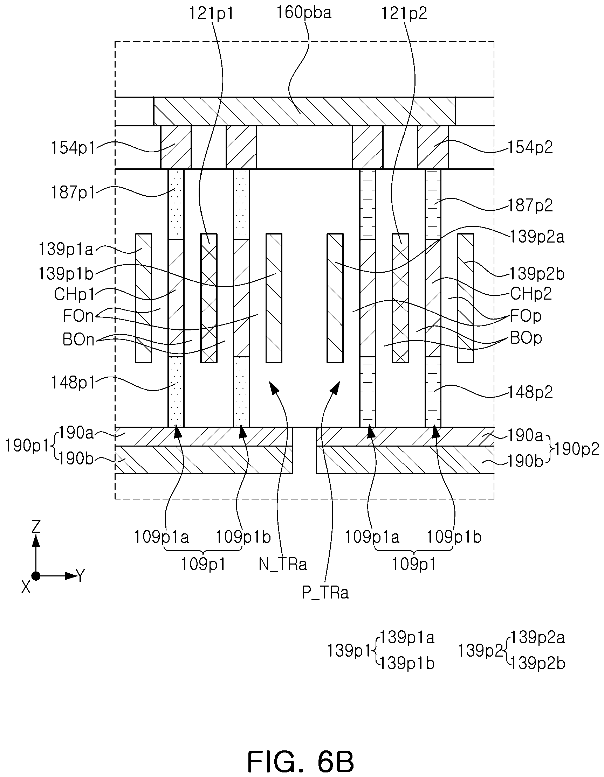

In the description below, an example embodiment of an inverter formed using the first to seventh peripheral NMOS transistors N_TRa, N_TRb, N_TRc, N_TRd, N_TRe, N_TRf, and N_TRg, the first to seventh peripheral PMOS transistors P_TRa, P_TRb, P_TRc, P_TRd, P_TRe, P_TRf, and P_TRg, the third peripheral NMOS gate electrode 121p 1 and the third peripheral PMOS gate electrode 121p2 in the first peripheral circuit region PR_U will be described with reference to FIGS. 6A and 6B. FIG. 6A is a plan diagram illustrating an example embodiment of an inverter in a semiconductor device according to an example embodiment, and FIG. 6B is a cross-sectional diagram illustrating a region corresponding to region "B" in FIG. 1B, taken along line I-I' in FIG. 6A.

In an example, referring to FIGS. 6A and 6B, the inverter INT may be configured using at least one of the first to seventh peripheral NMOS transistors N_TRa, N_TRb, N_TRc, N_TRd, N_TRe, N_TRf, and N_TRg, and at least one of the first to seventh peripheral PMOS transistors P_TRa, P TRb, P_TRc, P_TRd, P_TRe, P_TRf, and P_TRg, the third peripheral NMOS gate electrode 121p1 and the third peripheral PMOS gate electrode 121p2 in the first peripheral circuit region PR_U described above. For example, the inverter INT may include the first peripheral NMOS transistors N_TRa and the first peripheral PMOS transistors P_TRa, and the third NMOS peripheral gate electrode 121p1 and the third peripheral PMOS gate electrode 121p2 described with reference to FIGS. 1A and 1B.

The inverter INT may include the first and second NMOS vertical active patterns 109p1a and 109p1b adjacent to each other in the second horizontal direction Y, and the first and second PMOS vertical active patterns 109p2a and 109p2b adjacent to each other in the second horizontal direction Y.

A plurality of the first NMOS vertical active pattern 109p1a may be arranged and spaced apart from each other in the first horizontal direction X. A plurality of the second NMOS vertical active pattern 109p1b may be arranged and spaced apart from each other in the first horizontal direction X.

A plurality of the first PMOS vertical active pattern 109p2a may be arranged and spaced apart from each other in the first horizontal direction X. A plurality of the second PMOS vertical active pattern 109p2b may be arranged and spaced apart from each other in the first horizontal direction X.

The inverter INT may include the first lower peripheral wiring 190p1 and the second lower peripheral wiring 190p2 described with reference to FIG. 1B. The first lower peripheral wiring 190p1 described with reference to FIG. 1B may be connected to lower surfaces of the first NMOS vertical active patterns 109p1a, and the second lower peripheral wiring 190p2 described with reference to FIG. 1B may be connected to lower surfaces of the first PMOS vertical active patterns 109p2a.

The inverter INT may further include a gate contact structure G_C electrically connecting the first NMOS gate electrode 139p1a, the second NMOS gate electrode 139p1b, the first PMOS gate electrode 139p2a and the second PMOS gate electrode 139p2b to each other, as described with reference to FIG. 1B.

The inverter INT may further include an NMOS back gate contact structure nB_C electrically connected to the third NMOS gate electrode 121p1 and a PMOS back gate contact structure pB_C electrically connected to the third PMOS gate electrode 121p2.

The inverter INT may include the NMOS contact plugs 154p1 connected to the upper surfaces of the first NMOS vertical active patterns 109p1a and the PMOS contact plugs 154p2 connected to the upper surfaces of the first PMOS vertical active patterns 109p2a as described with reference to FIG. 1B.

The inverter INT may include a common upper wiring 160pba disposed on the NMOS contact plugs 154p1 and the PMOS contact plugs 154p2 and electrically connected to the NMOS contact plugs 154p1 and the PMOS contact plugs 154p2. The common upper wiring 160pba may be electrically connected to the upper NMOS source/drain regions 187p1 of the first NMOS vertical active patterns 109p1a and the upper PMOS source/drain regions 187p2 of the first PMOS vertical active patterns 109p2a through the NMOS contact plugs 154p1 and the PMOS contact plugs 154p2.

Using the first peripheral NMOS transistors N_TRa and the first peripheral PMOS transistors P_TRa, by applying a negative bias to the third NMOS gate electrode 121p1 and a positive bias to the third PMOS gate electrode 121p2, performance of the inverter INT may be improved during operation of the inverter INT. The third NMOS gate electrode 121p1 may be configured as an NMOS back gate electrode, and the third PMOS gate electrode 121p2 may be configured as a PMOS back gate electrode.

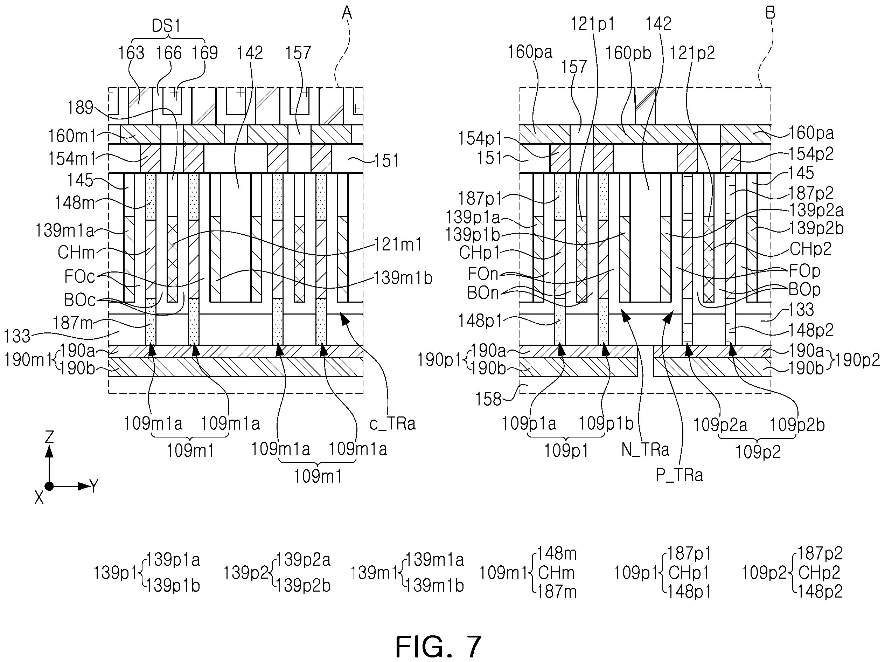

In the description below, example embodiments of the second insulating structure INS, the cell gate dielectric layers FOc, the cell back gate dielectric layers BOc, the NMOS gate dielectric layers FOn, the PMOS gate dielectric layers FOp, the third NMOS gate dielectric layers BOn and the third PMOS gate dielectric layers BOp in FIG. 1B will be described with reference to FIG. 7. FIG. 7 is an enlarged cross-sectional diagram illustrating regions corresponding to regions "A" and "B" in FIGS. 1A and 1B.

In an example, referring to FIG. 7, the second insulating structure INS may include upper gate capping insulating layers 145, upper back gate capping insulating layers 189, a buffer insulating layer 133, and gap-fill insulating layers 142.

The upper gate capping insulating layers 145 may be disposed on upper surfaces of the word lines 139m1 and the peripheral gate electrodes 139p1 and 139p2 described with reference to FIG. 1B. The upper back gate capping insulating layers 189 may be disposed on upper surfaces of the cell back gate electrodes 121m1 and the third peripheral gate electrodes 121p1 and 121p2 described with reference to FIG. 1B. The buffer insulating layer 133 may be disposed on upper surfaces of the bit lines 190m1 and 190m2, the lower peripheral wirings 190p1 and 190p2 and the first insulating structure 198. The gap-fill insulating layers 142 may be disposed between the word lines 139m1 without the cell vertical active pattern 109m1 therebetween among the word lines 139m1 adjacent to each other, and may be disposed between the peripheral gate electrodes 139p1 and 139p2 without the peripheral vertical active pattern 109p1 and 109p2 therebetween among the peripheral gate electrodes 139p1 and 139p2 adjacent to each other.

The cell gate dielectric layers FOc described with reference to FIG. 1B may extend from a portion disposed between the cell vertical active patterns 109m1 and the word lines 139m1 to regions between the cell vertical active patterns 109m1 and the upper gate capping insulating layers 145, between the lower surfaces of the word lines 139m1 and the buffer insulating layer 133, and between the lower surfaces of the gap-fill insulating layers 142 and the buffer insulating layer 133.

The cell back gate dielectric layers BOc described with reference to FIG. 1B may extend from a portion disposed between the cell vertical active patterns 109m1 and the cell back gate electrodes 121m1 to regions between the cell vertical active patterns 109m1 and the upper back gate capping insulating layers 189, and between the lower surfaces of the cell back gate electrodes 121m1 and the buffer insulating layer 133.

The NMOS and PMOS gate dielectric layers FOn and FOp described with reference to FIG. 1B may extend from a portion disposed between the peripheral vertical active patterns 109p1 and 109p2 and the peripheral gate electrodes 139p1 and 139p2 to regions between the peripheral vertical active patterns 109p1 and 109p2 and the upper gate capping insulating layers 145, between the lower surfaces of the peripheral vertical active patterns 109p1 and 109p2 and the buffer insulating layer 133, and between the lower surfaces of the gap-fill insulating layers 142 and the buffer insulating layer 133.

The third gate dielectric layers BOn and BOp described with reference to FIG. 1B may extend from a portion disposed between the peripheral vertical active patterns 109p1 and 109p2 and the third peripheral gate electrodes 121p1 and 121p2 to regions between the peripheral vertical active patterns 109p1 and 109p2 and the upper back gate capping insulating layers 189, and between the lower surfaces of the third peripheral gate electrodes 121p1 and 121p2 and the buffer insulating layer 133.

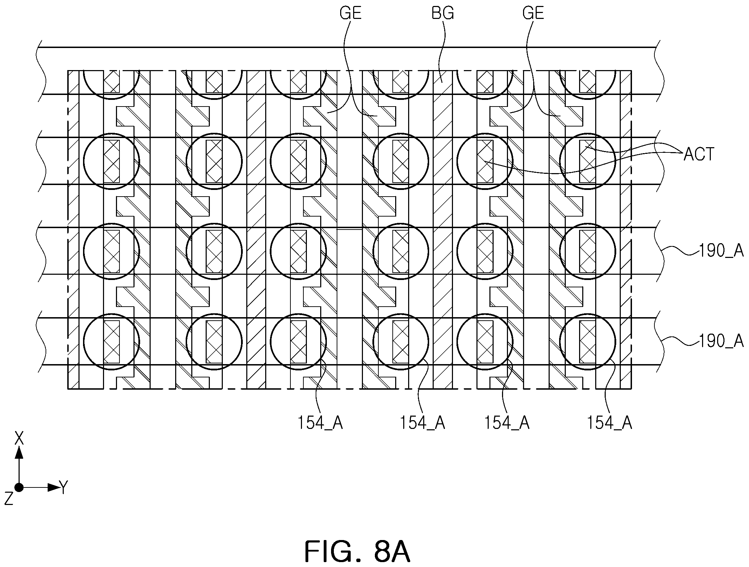

In the description below, example embodiments of planar shapes of various circuits configured using the first to seventh peripheral NMOS transistors N_TRa, N_TRb, N_TRc, N_TRd, N_TRe, N_TRf, and N_TRg and the first to seventh peripheral PMOS transistors P_TRa, P_TRb, P_TRc, P_TRd, P_TRe, P_TRf, and P_TRg and, the third peripheral NMOS gate electrode 121p1 and the third peripheral PMOS gate electrode 121p2 in the first peripheral circuit region PR_U will be described with reference to FIGS. 8A to 8F. FIGS. 8A to 8F are plan diagrams illustrating various examples of configuring a circuit in a semiconductor device according to an example embodiment.

In an example, referring to FIG. 8A, peripheral vertical active patterns ACT may be arranged in the first horizontal direction X and the second horizontal direction Y, perpendicular to each other. Each of the peripheral vertical active patterns ACT may having a bar shape extending in the first horizontal direction X.

The peripheral vertical active patterns ACT may be the NMOS vertical active pattern 109p1 described with reference to FIGS. 1A and 1B or the PMOS vertical active pattern 109p2 described with reference to FIGS. 1A and 1B.

In the description below, the example in which the peripheral vertical active patterns ACT is the NMOS vertical active pattern 109p1 described in FIGS. 1A and 1B will be described.

The peripheral gate electrodes GE may correspond to the NMOS gate electrodes 139p1 described with reference to FIGS. 1A and 1B. The third peripheral gate electrodes BG, which may correspond to the back gate electrode, may correspond to the third peripheral gate electrode 121p1 described with reference to FIGS. 1A and 1B, for example.

Each of the third peripheral gate electrodes BG may extend in the first horizontal direction X. The third peripheral gate electrodes BG may be parallel to each other.

A pair of peripheral gate electrodes GE among the peripheral gate electrodes GE may be disposed between a pair of the third peripheral gate electrodes BG adjacent to each other.

Lower peripheral wirings 190_A may correspond to the first lower peripheral wirings 190p1 described with reference to FIGS. 1A and 1B. Each of the lower peripheral wirings 190_A may have a line shape extending in the second horizontal direction Y. The lower peripheral wirings 190_A may be parallel to each other.

Peripheral contact structures 154_A may correspond to the first peripheral contact structures 154p1 described with reference to FIGS. 1A and 1B. The peripheral contact structures 154_A may be connected to the peripheral vertical active patterns ACT, respectively. For example, the peripheral contact structure 154_A may be connected to the peripheral vertical active pattern ACT.

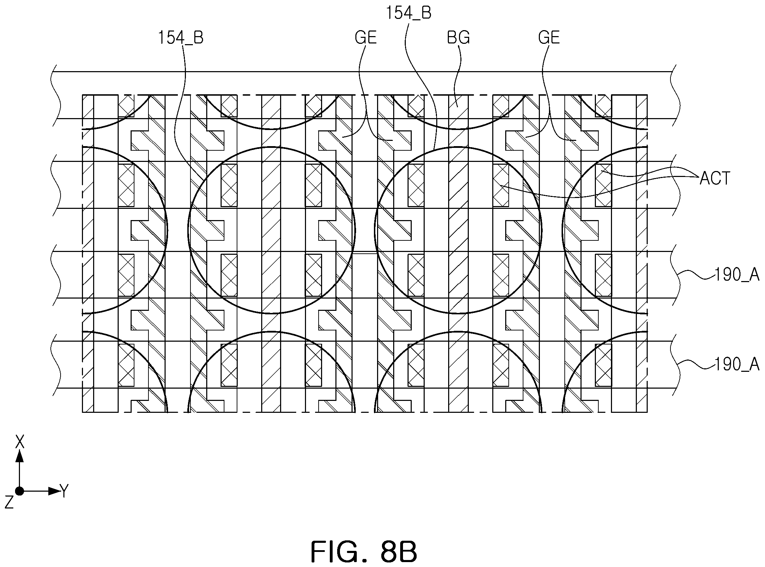

In another example, referring to FIG. 8B, the peripheral contact structures 154_A described with reference to FIG. 8A may be modified to peripheral contact structures 154_B as in FIG. 8B. For example, the peripheral contact structures 154_B may be connected to a plurality of the peripheral vertical active patterns ACT, respectively. In other words, the peripheral contact structure 154_B may be connected to the plurality of peripheral vertical active patterns ACT. The peripheral contact structures 154_B may be spaced apart from each other. Each of the peripheral contact structures 154_B may have a circular shape or a quadrangular shape.

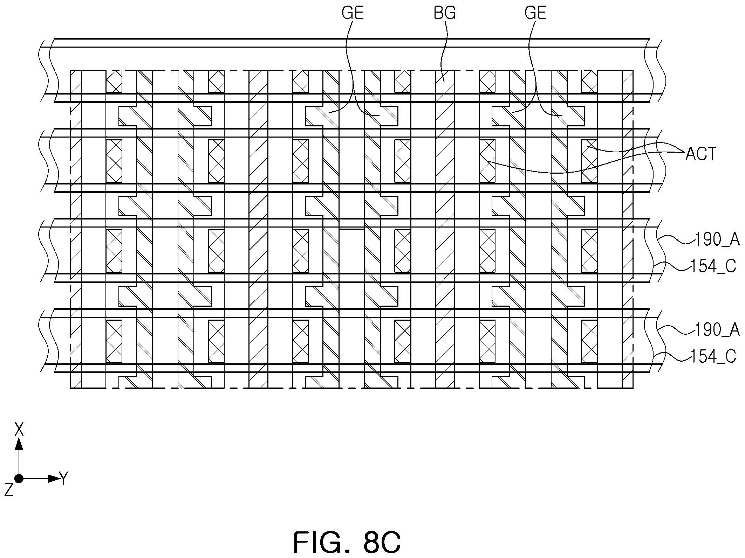

In another example, referring to FIG. 8C, the peripheral contact structures 154_A described with reference to FIG. 8A may be modified to peripheral contact structures 154_C as in FIG. 8C. For example, each of the peripheral contact structures 154_C may have a line shape extending in the second horizontal direction Y, and may be connected to the peripheral vertical active patterns ACT. The peripheral contact structures 154_C may vertically overlap the lower peripheral wirings 190_A.

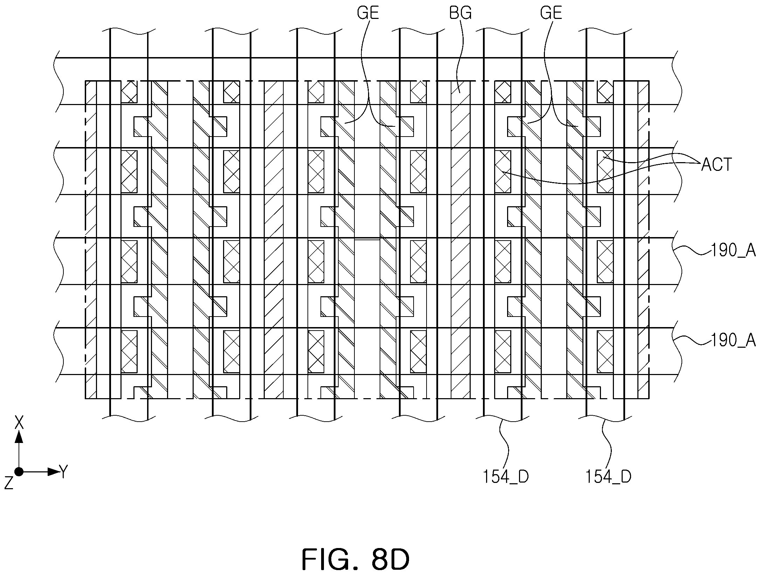

In another example, referring to FIG. 8D, the peripheral contact structures 154_A described with reference to FIG. 8A may be modified to peripheral contact structures 154_D as in FIG. 8D. For example, each of the peripheral contact structures 154_D may have a line shape extending in the first horizontal direction X, and may be connected to the peripheral vertical active patterns ACT. The peripheral contact structures 154_D may have a line shape extending in a direction intersecting the lower peripheral wirings 190_A.

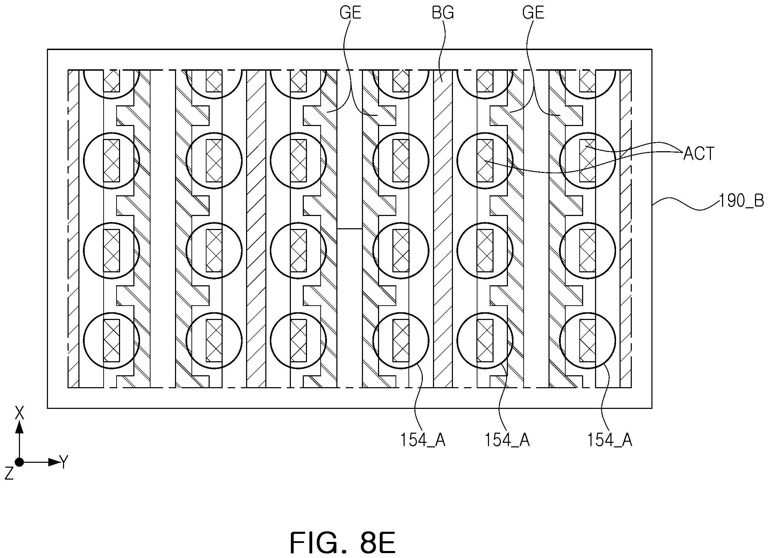

In another example, referring to FIG. 8E, the lower peripheral wirings 190_A in FIGS. 8A to 8D may be modified to lower peripheral wirings 190_B as in FIG. 8E.

The lower peripheral wiring 190_B may be configured as a conductive plate connected to the entire peripheral vertical active patterns ACT.

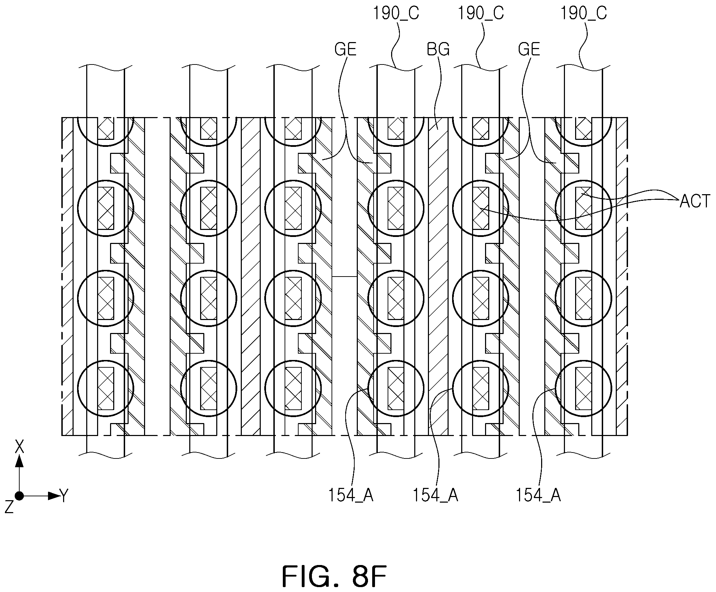

In another example, referring to FIG. 8F, the lower peripheral wirings 190_A in FIGS. 8A to 8D may be modified to lower peripheral wirings 190_C as in FIG. 8F.

Each of the lower peripheral wirings 190_C may extend in the first horizontal direction X and may be connected to the peripheral vertical active patterns ACT. The lower peripheral wirings 190_C may be parallel to each other.

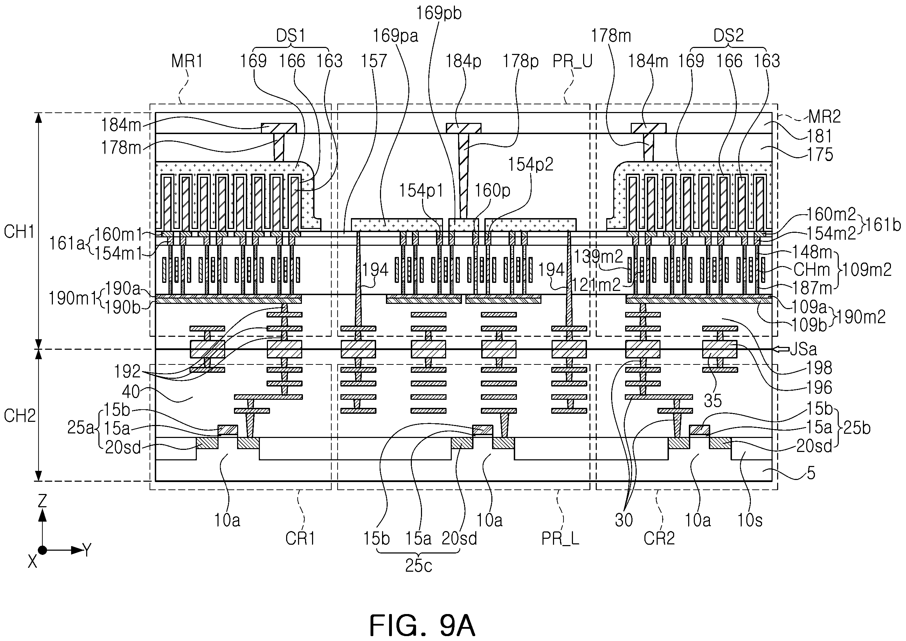

In the description below, an example of the upper peripheral wirings 160pa and 160pb of the first peripheral circuit region PR_U described with reference to FIGS. 1A and 1B will be described with reference to FIG. 9A. FIG. 9A may illustrate an example of the upper peripheral wirings 160pa and 160pb of the first peripheral circuit region PR_U in the cross-sectional structure as in FIG. 1A.

Referring to FIG. 9A, the upper peripheral wirings 160pa and 160pb described with reference to FIGS. 1A and 1B may be replaced with peripheral pad patterns 160p disposed on the same level as a level of the cell pad patterns 160m1. Upper peripheral wirings 169pa and 169pb having substantially the same shape as that of the upper peripheral wirings 160pa and 160pb described with reference to FIGS. 1A and 1B may be disposed on the peripheral pad patterns 160p. A portion of the lower region of the second electrode 169 may be disposed on the same level as a level of the upper peripheral wirings 169pa and 169pb. For example, lower surfaces of the upper peripheral wirings 169pa, 169pb may be disposed on a level lower than a level of the second electrode 169, and upper surfaces of the upper peripheral wirings 169pa, 169pb may be disposed on a level higher than a level of the lower surface of the second electrode 169 and lower than the upper surface of the second electrode 169. The upper peripheral wirings 169pa and 169pb may be disposed on the same level as a level of a portion of the second electrode 169. The upper peripheral wirings 169pa and 169pb may be formed of the same conductive material as that of the second electrode 169.

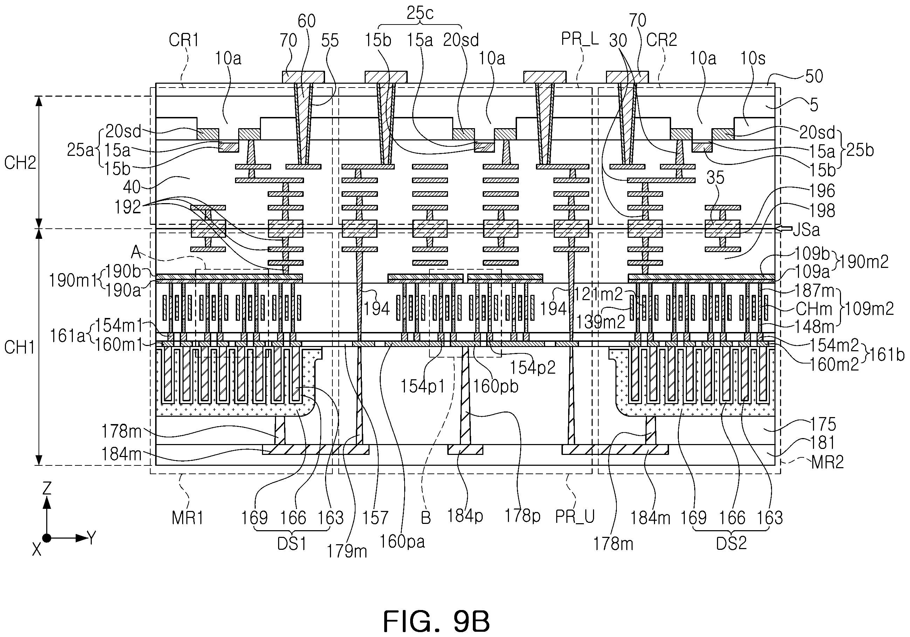

In the description below, an example of a semiconductor device according to an example embodiment will be described with reference to FIG. 9B. FIG. 9B is a cross-sectional diagram illustrating an example of a semiconductor device according to an example embodiment.

Referring to FIG. 9B, the structure including the first and second structures CH1 and CH2 in FIG. 1A may be disposed upside down. For example, the second structure CH2 may be disposed on the first structure CH1.

The first structure CH1 may further include a routing structure 179m electrically connecting the cell upper wirings 184m to the first and second bonding pads 35 and 196 between the cell upper wirings 184m and the second structure CH2. In the first structure CH1, the bit lines 190m1 and 190m2 may be closer to the second structure CH2 than the data storage structures DS1 and DS2.

The second structure CH2 may further include a backside insulating layer 50 on the substrate 5, a through-electrode 60 penetrating the backside insulating layer 50 and the substrate 5 and electrically connected to the second routing wiring structure 30, an insulating spacer 55 on a side surface of the through-electrode 60, and a conductive pad 70 connected to the through-electrode 60 on the backside insulating layer 50.

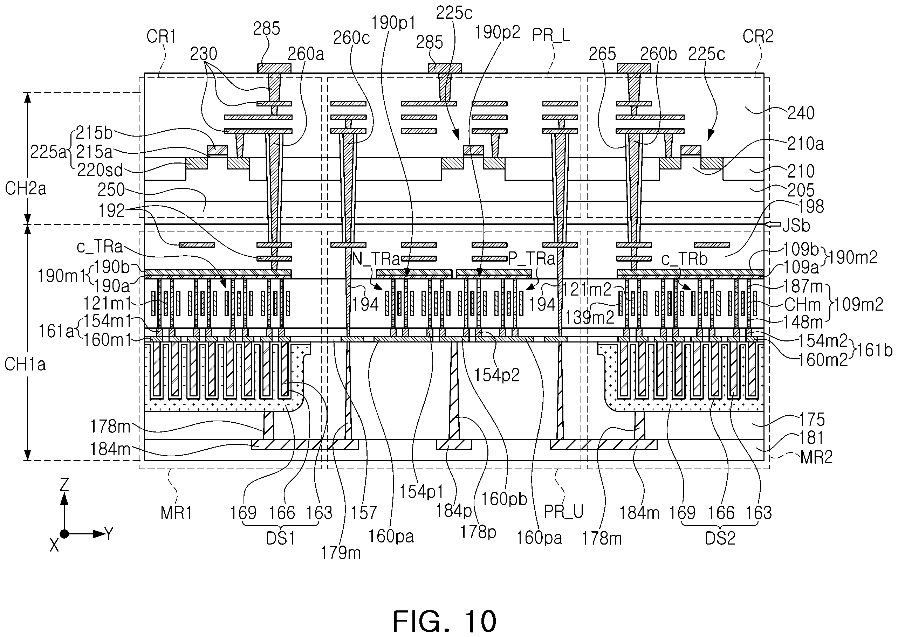

In the description below, an example of a semiconductor device according to an example embodiment will be described with reference to FIG. 10. FIG. 10 is a cross-sectional diagram illustrating an example of a semiconductor device according to an example embodiment.

Referring to FIG. 10, the first structure CH1 having the first and second memory regions MR1 and MR2 and the first peripheral circuit region PR_U described with reference to FIGS. 1A and 1B may be modified to first structure CH1a having first and second memory regions MR1 and MR2 and first peripheral circuit region PR_U as in FIG. 10. The second structure CH2 having the first and second core circuit regions CR1 and CR2 and the second peripheral circuit region PR_L described in FIGS. 1A and 1B may be modified to a second structure CH2a having first and second core circuit regions CR1 and CR2 and second peripheral circuit region PR_L as in FIG. 10. The second structure CH2a may be disposed on the first structure CH1a as illustrated in FIG. 10.

The first structure CH1a may be substantially the same as the first structure (CH1 in FIG. 1A) in FIG. 1A in which the first bonding pads (196 in FIG. 1A) is not provided. Accordingly, the first insulating structure 198 as in FIG. 1A may be bonded to the second structure CH2a.

The second structure CH2a may include a substrate 205 and a device isolation region 210 limiting active regions 210a on the substrate 205. The substrate 205 may be configured as a semiconductor substrate.

The first structure CH1 may further include a routing structure 179m electrically connecting the cell upper wirings 184m to the second routing wiring structure 192 between the cell upper wirings 184m and the second structure CH2. In the first structure CH1, the bit lines 190m1 and 190m2 may be closer to the second structure CH2 than the data storage structures DS1 and DS2.

The second structure CH2a may include a lower peripheral circuit transistors 225a, 225b, 225c disposed on the substrate 205, a second routing wiring structure 230 electrically connected to the lower peripheral circuit transistors 225a, 225b, and 225c on the lower peripheral circuit transistors 225a, 225b, and 225c, and a lower insulating structure 240 covering the lower peripheral circuit transistors 225a, 225b, 225c and the second routing wiring structure 230 on the substrate 205.

The lower peripheral circuit transistors 225a, 225b, and 225c may include peripheral gate structures 215a, 215b and peripheral source/drain regions 220sd, respectively. The peripheral gate structures 215a and 215b may include a peripheral gate dielectric layer 215a and a peripheral gate electrode 215b.

The lower peripheral circuit transistors 225a, 225b, and 225c may include a first core circuit transistor 225a in the first core circuit region CR1, a second core circuit transistor 225b in the second core circuit region CR2, and a second peripheral circuit transistor 225c in the second peripheral circuit region PR_L.

The first core circuit region CR1 may include the first core circuit transistor 225a. The second core circuit region CR2 may include the second core circuit transistor 225b. The first core circuit transistor 225a may vertically overlap the first data storage structure DS1, and the second core circuit transistor 225b may vertically overlap the second data storage structure DS2.

The second structure CH2a may be disposed below the substrate 205 and may further include a backside insulating layer 250 bonded to the first insulating structure 198. The lower surface of the backside insulating layer 250 and the upper surface of the first insulating structure 198 may be bonded to form a bonding surface JSb between the first structure CH1a and the second structure CH2a.

The second structure CH2a may include through-electrodes 260a, 260b, 260c, and insulating spacers 265 surrounding a side surface of each of the through-electrodes 260a, 260b, and 260c. Through-electrodes 260a, 260b, 260c may penetrate the substrate 5, extend upwardly, and connect to the second routing wiring structure 230, and may penetrate the substrate 5 and the insulating layer 250, extend downwardly and connect to the first routing wiring structure 192 in the first structure CH1a.

The upper surfaces of the through-electrodes 260a, 260b, and 260c may be connected to the second routing wiring structure 230, and the lower surfaces of the through-electrodes 260a, 260b, and 260c may be connected to the first routing structure 192.

The through-electrodes 260a, 260b, and 260c may include a first through-electrode 260a electrically connecting the first core circuit transistor 225a to the first bit line 190m1, a second through-electrode 260b electrically connecting the second core circuit transistor 225b to the second bit line 190m2, and a third through-electrode 260c disposed in the first and second peripheral circuit regions PR_L and PR_U.

The second structure CH2a may further include a conductive pad 285 disposed on the lower insulating structure 240 and electrically connected to the second routing wiring structure 230.

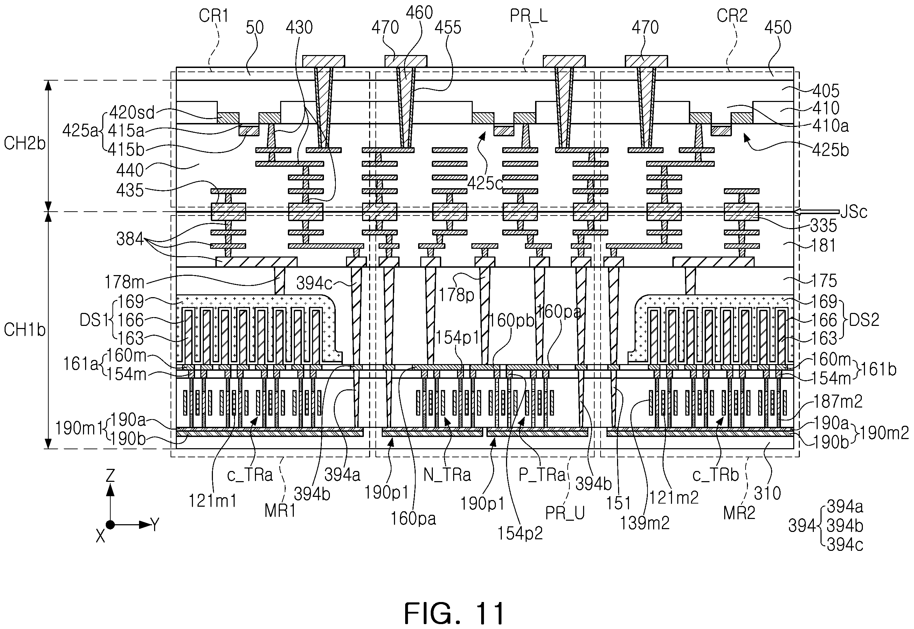

In the description below, an example of a semiconductor device according to an example embodiment will be described with reference to FIG. 11. FIG. 11 is a cross-sectional diagram illustrating an example of a semiconductor device according to an example embodiment.

Referring to FIG. 11, the first structure CH1 having the first and second memory regions MR1 and MR2 and the first peripheral circuit region PR_U described with reference to FIGS. 1A and 1B may be modified to first structure CH1b having first and second memory regions MR1 and MR2 and first peripheral circuit region PR_U as in FIG. 11. The second structure CH2 having the first and second core circuit regions CR1 and CR2 and the second peripheral circuit region PR_L described in FIGS. 1A and 1B may be modified to a second structure CH2b having first and second core circuit regions CR1 and CR2 and second peripheral circuit region PR_L as in FIG. 11.

The first structure CH1b may not be provided with the first bonding pads (196 in FIG. 1A), the first routing wiring structure 192, the connection contact plugs 194, the cell upper wirings 184m and the third peripheral upper wiring 184p, differently from the first structure (CH1 in FIG. 1A), and may further include an upper routing wiring structure 384 disposed in the upper insulating structure 181, and a first bonding pads 335 having an upper surface coplanar with the upper surface of the upper insulating structure 181 and electrically connected to the upper routing wiring structure 384, differently from the first structure (CH1 in FIG. 1A).

The first structure CH1b may further include connection routing structures 394 connecting the first and second bit lines 190m1 and 190m2 to the upper routing wiring structure 384, differently from the first structure (CH1 in FIG. 1A) in FIG. 1A.

Each of the connection routing structures 394 may include an upper plug 394c disposed on the same level as a level of the peripheral contact plug 178p and connected to the upper routing wiring structure 384, an intermediate pad pattern 394b disposed on the same level as a level of the cell pad pattern 160m, and a lower plug 394a disposed between the first and second bit lines 190m1 and 190m2 and the intermediate pad pattern 394b.

The second structure CH2b may be disposed on the first structure CH1b.

The second structure CH2b may include a substrate 405 and a device isolation region 410 limiting the active regions 410a below the substrate 405. The substrate 405 may be configured as a semiconductor substrate.

The second structure CH2b may include lower peripheral circuit transistors 425a, 425b, 425c disposed below the substrate 405, a second routing wiring structure 430 electrically connected to the lower peripheral circuit transistors 425a, 425b, and 425c below the lower peripheral circuit transistors 425a, 425b, and 425c, a lower insulating structure 440 covering the lower peripheral circuit transistors 425a, 425b, 425c, the second routing wiring structure 430 under the substrate 405, and first bonding pads 435 having a lower surface coplanar with a lower surface of the lower insulating structure 440.

Each of the lower peripheral circuit transistors 425a, 425b, and 425c may include peripheral gate structures 415a and 415b and peripheral source/drain regions 420sd. The peripheral gate structures 415a and 415b may include a peripheral gate dielectric layer 415a and a peripheral gate electrode 415b.

The lower peripheral circuit transistors 425a, 425b, and 425c may include a first core circuit transistor 425a in the first core circuit region CR1, a second core circuit transistor 425b in the second core circuit region CR2, and a second peripheral circuit transistor 425c in the second peripheral circuit region PR_L.

The first core circuit region CR1 may include the first core circuit transistor 425a. The second core circuit region CR2 may include the second core circuit transistor 425b. The first core circuit transistor 425a may vertically overlap the first data storage structure DS1, and the second core circuit transistor 425b may vertically overlap the second data storage structure DS2.

A lower surface of the lower insulating structure 440 of the second structure CH2b may be bonded to an upper surface of the upper insulating structure 181 of the first structure CH1b, and lower surfaces of the second bonding pads 435 of the second structure CH2b may be bonded to the upper surface of the upper insulating structure 181 of the first structure CH1b. The second structure CH2b may be bonded to upper surfaces of the first bonding pads 335 of the first structure CH1b, and the lower surfaces of the second bonding pads 435 may be bonded to the upper surfaces of the first bonding pads 335. Accordingly, the bonding surface JSc formed by bonding the upper surface of the first structure CH1b to the lower surface of the second structure CH2b may be formed.

The second structure CH2b may further include a backside insulating layer 450 on the substrate 405, a through-electrode 460 penetrating the backside insulating layer 450 and the substrate 405 and electrically connected to the second routing wiring structure 430, an insulating spacer 455 on a side surface of the through-electrode 460, and a conductive pad 470 connected to the through-electrode 460 on the backside insulating layer 450.

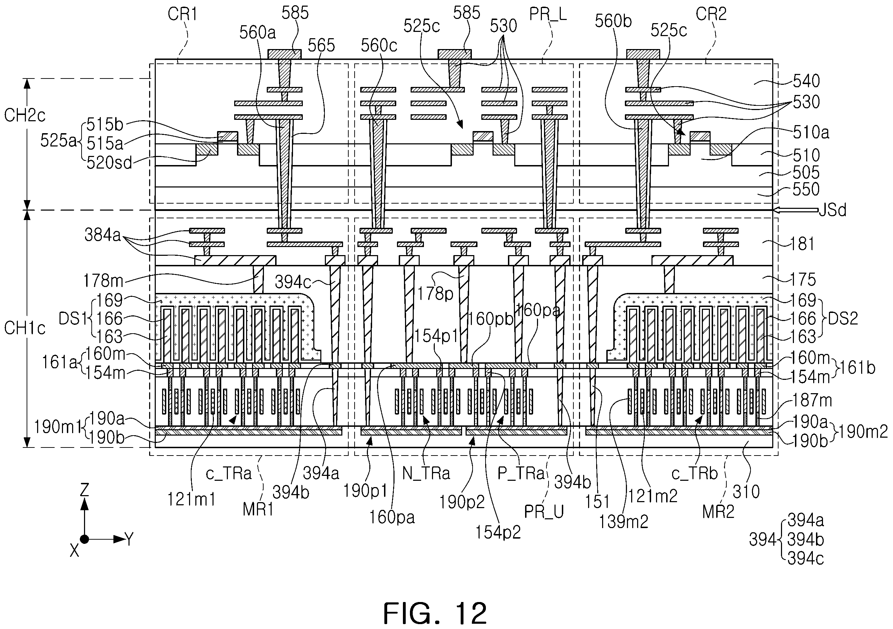

In the description below, an example of a semiconductor device according to an example embodiment will be described with reference to FIG. 12. FIG. 12 is a cross-sectional diagram illustrating an example of a semiconductor device according to an example embodiment.

Referring to FIG. 12, the first structure CH1b having the first and second memory regions MR1 and MR2 and the first peripheral circuit region PR_U described with reference to FIG. 11 may be modified to first structure CH1c with first and second memory regions MR1 and MR2 and first peripheral circuit region PR_U as in FIG. 12. The second structure CH2b having the first and second core circuit regions CR1 and CR2 and the second peripheral circuit region PR_L described in FIG. 11 may be modified to a second structure CH2c having first and second core circuit regions CR1 and CR2 and second peripheral circuit region PR_L as in FIG. 12.

The first structure CH1c may be substantially the same as the first structure (CH1b in FIG. 11) in FIG. 11 in which the first bonding pads (335 in FIG. 11) is not provided. Accordingly, the upper surface of the upper insulating structure 181, as illustrated in FIG. 12, may be bonded to the lower surface of the second structure CH2c.

The second structure CH2c may include a substrate 505 and a device isolation region 510 limiting active regions 510a on the substrate 505. The substrate 505 may be configured as a semiconductor substrate.

The second structure CH2c may include a lower peripheral circuit transistors 525a, 525b, and 525c disposed on the substrate 505, a second routing wiring structure 530 electrically connected to the lower peripheral circuit transistors 525a, 525b, and 525c on the lower peripheral circuit transistors 525a, 525b, and 525c, a lower insulating structure 540 covering the lower peripheral circuit transistors 525a, 525b, and 525c and the second routing wiring structure 530 on the substrate 505, and the insulating layer 550 disposed below the substrate 505.

The lower surface of the insulating layer 550 and the upper surface of the upper insulating structure 181 may be bonded to form a bonding surface JSd between the first structure CH1c and the second structure CH2c.

The lower peripheral circuit transistors 525a, 525b, and 525c may include peripheral gate structures 515a, 515b, and peripheral source/drain regions 520sd, respectively. The peripheral gate structures 515a and 515b may include a peripheral gate dielectric layer 515a and a peripheral gate electrode 515b.

The lower peripheral circuit transistors 525a, 525b, and 525c may include a first core circuit transistor 525a in the first core circuit region CR1, a second core circuit transistor 525b in the second core circuit region CR2, and a second peripheral circuit transistor 525c in the second peripheral circuit region PR_L.

The first core circuit region CR1 may include the first core circuit transistor 525a. The second core circuit region CR2 may include the second core circuit transistor 525b. The first core circuit transistor 525a may vertically overlap the first data storage structure DS1, and the second core circuit transistor 525b may vertically overlap the second data storage structure DS2.

The second structure CH2c may include through-electrodes 560a, 560b, and 560c, and insulating spacers 565 surrounding a side surface of each of the through-electrodes 560a, 560b, and 560c. Through-electrodes 560a, 560b, and 560c may penetrate the substrate 505, extend upwardly, and connect to the second routing wiring structure 530, and may penetrate the substrate 505 and the insulating layer 550, extend downwardly and connect to the first routing wiring structure 384a in the first structure CH1c.

The upper surfaces of the through-electrodes 560a, 560b, and 560c may be connected to the second routing wiring structure 530, and the lower surfaces of the through-electrodes 560a, 560b, and 560c may be connected to the first routing structure 384a.

The through-electrodes 560a, 560b, and 560c may include a first through-electrode 560a electrically connecting the first core circuit transistor 525a to the first bit line 190m1, a second through-electrode 560b electrically connecting the second core circuit transistor 525b to the second bit line 190m2, and a third through-electrode 560c disposed in the first and second peripheral circuit regions PR_L and PR_U.

The second structure CH2c may further include a conductive pad 585 disposed on the lower insulating structure 540 and electrically connected to the second routing wiring structure 530.

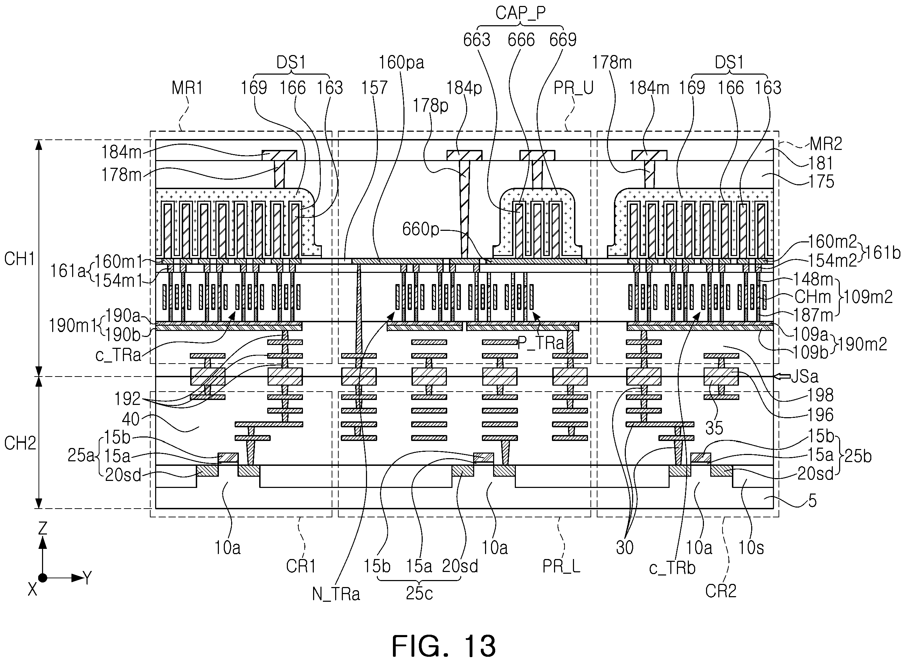

In the description below, an example of a semiconductor device according to an example embodiment will be described with reference to FIG. 13. FIG. 13 is a cross-sectional diagram illustrating an example of a semiconductor device according to an example embodiment.

Referring to FIG. 13, the example embodiments in FIGS. 1A to 12 may further include a power capacitor CAP _P disposed in the first peripheral circuit region PR_U and having a structure similar to that of the data storage structures DS1 and DS2, and an electrode connection pattern 660p connected to the power capacitor CAP _P. For example, the first structure CH1 as in FIG. 1A may further include the power capacitor CAP_P and the electrode connection pattern 660p.

The power capacitor CAP_P may include a first power electrode 663 disposed on the same level as a level of the first electrode 163, a second power electrode 669 disposed on the same level as a level of the second electrode 169, and a dielectric layer 666 between the first power electrodes 663 and the second power electrode 669.

The electrode connection pattern 660p may be disposed on the same level as a level of the cell pad patterns 161m1 and 160m2, and may be connected to the lower surfaces of the first power electrodes 663.

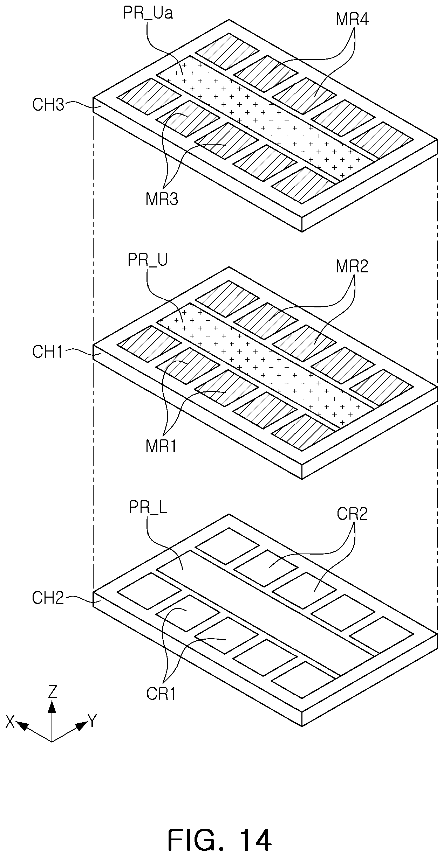

In the description below, an example embodiment of a semiconductor device according to an example embodiment will be described with reference to FIG. 14. FIG. 14 is a perspective diagram illustrating a semiconductor device according to an example embodiment.

Referring to FIG. 14, in an example, one of the example embodiments in FIGS. 1A to 13 may further include a third structure CH3 to increase integration density. For example, the semiconductor device 1 described with reference to FIGS. 1A and 1B may further include the third structure CH3 disposed on the first structure CH1. Similarly, as illustrated in FIG. 13, the third structure CH3 may be disposed on the first structure CH1 including the power capacitor (CAP _P in FIG. 13). FIG. 14 illustrates an example in which the semiconductor device 1 in FIG. 1A further includes the third structure CH3, but an example embodiment thereof is not limited thereto. For example, in example embodiments as in FIGS. 11 and 12, the third structure CH3 may be disposed below the first structures CH1b and CH1c.

In one of the example embodiments in FIGS. 1A to 13, a plurality of the first memory region MR1 may be arranged in the first horizontal direction X, a plurality of the second memory region MR2 may be arranged in the first horizontal direction X, a plurality of the first core circuit region CR1 may be arranged in the first horizontal direction X, and a plurality of the second core circuit region CR2 may be arranged in the first horizontal direction X. The plurality of first memory regions MR1 and the plurality of first core circuit regions CR1 described above may overlap in the vertical direction Z, and the plurality of second memory regions MR2 and the plurality of second core circuit regions CR2 may overlap in the vertical direction Z.

The first peripheral circuit region PR_U may be disposed between the plurality of first memory regions MR1 and the plurality of second memory regions MR2. The second peripheral circuit region PR_L may be disposed between the plurality of first core circuit regions CR1 and the plurality of second core circuit regions CR2.

The third structure CH3 may include a plurality of third memory regions MR3 vertically overlapping the plurality of first memory regions MR1, and a fourth memory regions MR4 vertically overlapping the plurality of second memory regions MR2.

The third and fourth memory regions MR3 and MR4 may include cell transistors (c_TRa and c_TRb in FIGS. 1A and 1B) and the data storage structures (DS1, DS2 in FIG. 1A) substantially the same as the first and second memory regions MR1 and MR2.

The third structure CH3 may include a third peripheral circuit region PR_Ua vertically overlapping the first peripheral circuit region PR_U, but in example embodiments, the third peripheral circuit region PR_Ua may not be provided.

In the other example embodiment, the third and fourth memory regions MR3 and MR4 may be formed on the first and second memory regions MR1 and MR2 in the first structure CH1 without separately forming the third structure CH3. For example, the first structure CH1 may further include the third and fourth memory regions MR3 and MR4 disposed on the first and second memory regions MR1 and MR2, and vertically overlapping the first and second memory regions MR1 and MR2.

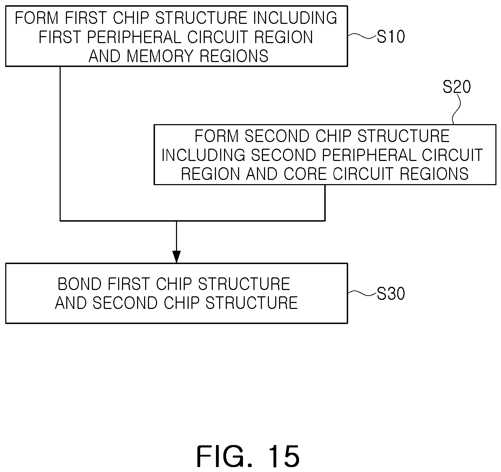

In the description below, a method of manufacturing a semiconductor device according to an example embodiment will be described with reference to FIG. 15. FIG. 15 is a flowchart illustrating a method of manufacturing a semiconductor device according to an example embodiment.

Referring to FIG. 15, a first structure including the first peripheral circuit region and memory regions may be formed (S10). The first structure may be the first structure of one of the example embodiments in FIGS. 1A to 14. For example, the first structure may be the first structure CH1 in FIG. 1A or FIG. 13, the first peripheral circuit region may be the first peripheral circuit region PR_U in FIG. 1A or FIG. 13, and the memory regions may be the first and second memory regions MR1 and MR2 in FIG. 1A or 13.

A second structure including a second peripheral circuit region and core circuit regions may be formed (S20). The second structure may be the second structure of any of the example embodiments in FIGS. 1A to 14. For example, the second structure may be the second structure CH2 in FIG. 1A or FIG. 13, the second peripheral circuit region may be the second peripheral circuit region PR_L in FIG. 1A or FIG. 13, and the core circuit regions may be the first and second core circuit regions CR1 and CR2 in FIG. 1A or FIG. 13.

The first structure and the second structure may be bonded to each other (S30). Accordingly, the first structure and the second structure bonded to each other may be formed. For example, as illustrated in FIG. 1A, the first structure CH1 and the second structure CH2 bonded to each other may be formed.

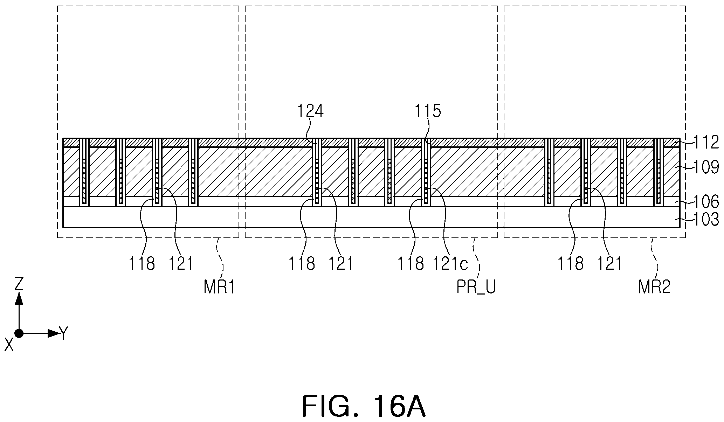

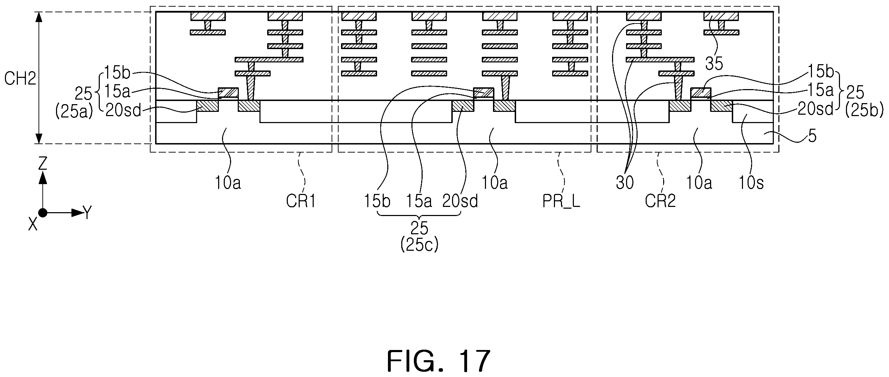

In the description below, a method of manufacturing a semiconductor device according to an example embodiment will be described with reference to FIGS. 16A to 16H, and FIG. 17. FIG. 15 is a flowchart illustrating a method of manufacturing a semiconductor device according to an example embodiment, and FIGS. 16A to 16H, and FIG. 17 are cross-sectional diagrams illustrating a semiconductor device according to an example embodiment.

Referring to FIG. 16A, a sacrificial substrate 103, a buffer insulating layer 106, a semiconductor layer 109 and an insulating layer 112 may be stacked in order. The semiconductor layer 109 may be formed of a semiconductor material such as single crystal silicon.

Trenches 115 penetrating the insulating layer 112, the semiconductor layer 109 and the buffer insulating layer 106 may be formed. The trenches 115 may be formed in the first memory region MR1, the first peripheral circuit region PR_U, and the second memory region MR2, arranged in order in the second horizontal direction Y.

Each of the trenches 115 may have a line shape extending in the first horizontal direction X. The semiconductor layers 109 may be spaced apart from each other in the second horizontal direction Y by the trenches 115.

A back gate dielectric layer 118 conformally covering internal walls of the trenches 115 may be formed, a back gate conductive layer may be formed on the back gate dielectric layer 118, preliminary back gate electrodes 121 partially filling the trenches 115 may be formed by partially etching the back gate conductive layer through an etch back process, back gate capping insulating layers 124 filling the other portions of the trenches 115 may be formed on the preliminary back gate electrodes 121. The back gate capping insulating layers 124 may be formed of an insulating material.

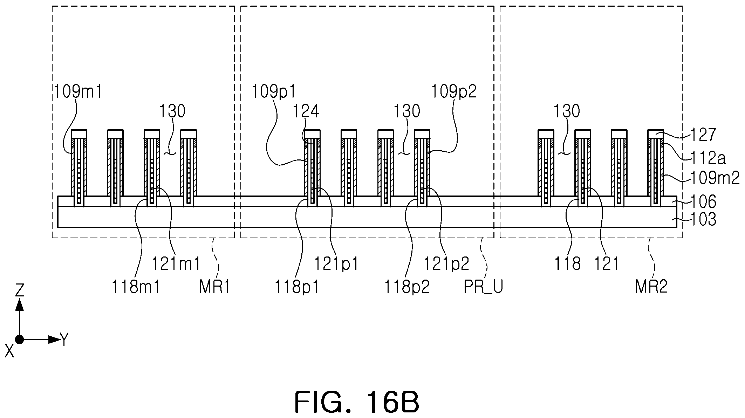

Referring to FIG. 16B, the mask pattern 127 may be formed, and vertical active patterns 109m1, 109p1, 109p2, and 109m2 may be formed by patterning the semiconductor layers (109 in FIG. 16A). In the cross-sectional structure as illustrated in FIG. 16B, pair of vertical active patterns adjacent to each other among the vertical active patterns 109m1, 109p1, 109p2, and 109m2 may be formed on both sides of one of the preliminary back gate electrodes 121.

The vertical active patterns 109m1, 109p1, 109p2, and 109m2 may include first cell vertical active patterns 109m1 in the first memory region MR1, second cell vertical active patterns 109m2 in the second memory region MR2, and NMOS vertical active patterns 109p1 and PMOS vertical active patterns 109p2 in the first peripheral circuit region PR_U.

The insulating layer (112 in FIG. 16A) may include the insulating patterns 112a remaining on the vertical active patterns 109m1, 109p1, 109p2, and 109m2. The insulating patterns 112a may protect upper surfaces of the vertical active patterns 109m1, 109p1, 109p2, and 109m2 during the process of patterning the semiconductor layer (109 in FIG. 16A). Openings 130 may be formed by etching the semiconductor layer (109 in FIG. 16A). The openings 130 may expose the buffer insulating layer 106.

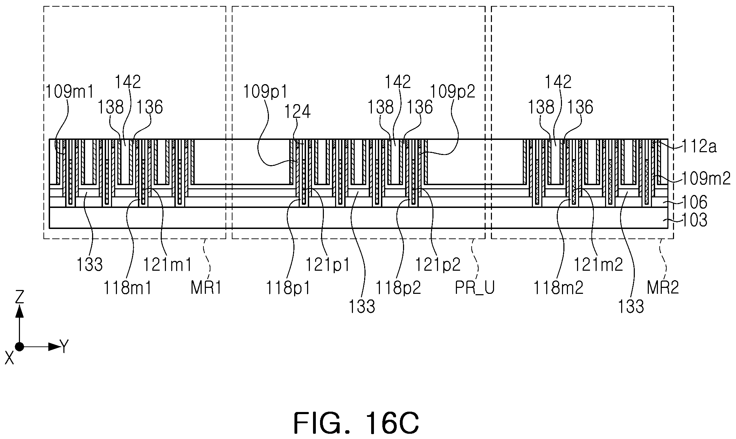

Referring to FIG. 16C, a further buffer insulating layer 133 may be disposed on the buffer insulating layer 106 and a gate dielectric layer 136 conformally covering internal walls of the openings 130 may then be formed, a preliminary gate conductive layer conformally covering the gate dielectric layer 136 may be formed, gate conductive layers 138 may be formed by anisotropically etching the preliminary gate conductive layer, and gate isolation insulating layers 142 filling the openings 130 may be formed on the gate conductive layers 138. The mask pattern 127 may be removed.

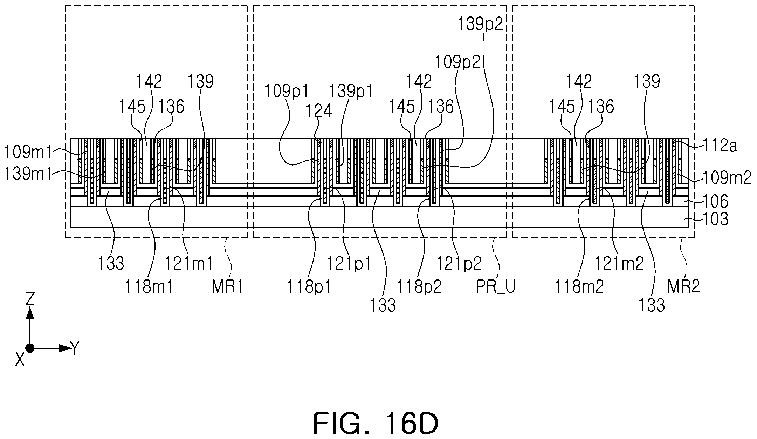

Referring to FIG. 16D, gate electrodes 139m1, 139p1, 139p2, and 139m2 may be formed by partially etching the gate conductive layers 138. The gate electrodes 139m1, 139p 1, 139p2, and 139m2 may include first word lines 139m1 in the first memory region MR1, second word lines 139m2 in the second memory region MR2, and peripheral NMOS gate electrodes 139p1 and peripheral PMOS gate electrodes 139p2 in the first peripheral circuit region PR_U. Upper gate capping insulating layers 145 may be formed on the gate electrodes 139m1, 139p1, 139p2, and 139m2.

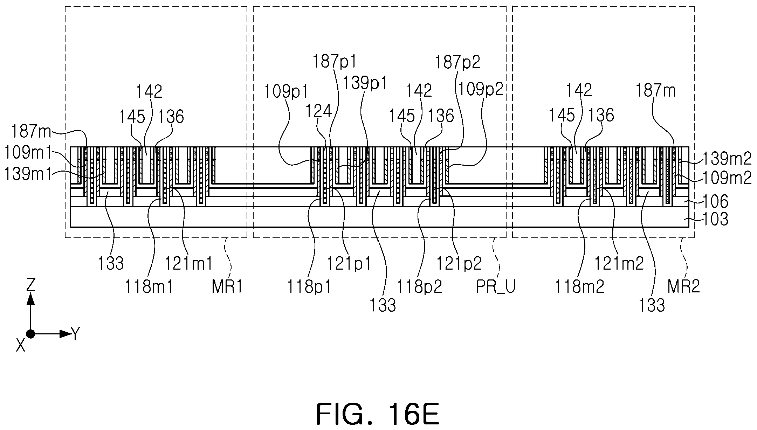

Referring to FIG. 16E, a planarization process may be performed until the upper surfaces of the vertical active patterns 109m1, 109p1, 109p2, and 109m2 are exposed. Accordingly, the insulating patterns 112a may be removed.

By performing the first ion implantation process, upper cell source/drain regions 187m may be formed in upper regions of the first and second cell vertical active patterns 109m1 and 109m2. The upper cell source/drain regions 187m may have N-type conductivity.

By performing the second ion implantation process, upper NMOS source/drain regions 187p 1 may be formed in the upper regions of the NMOS vertical active patterns 109p1. The upper NMOS source/drain regions 187p1 may have N-type conductivity.

In an example, the upper NMOS source/drain regions 187p1 may have a doping concentration different from that of the upper cell source/drain regions 187m.

In another example, when the upper NMOS source/drain regions 187p1 has the same doping concentration as that of the upper cell source/drain regions 187m, the first and second ion implantation processes may be performed as an integrated process.

By performing the third ion implantation process, upper PMOS source/drain regions 187p2 may be formed in the upper regions of the PMOS vertical active patterns 109p2. The upper PMOS source/drain regions 187p2 may have P-type conductivity.

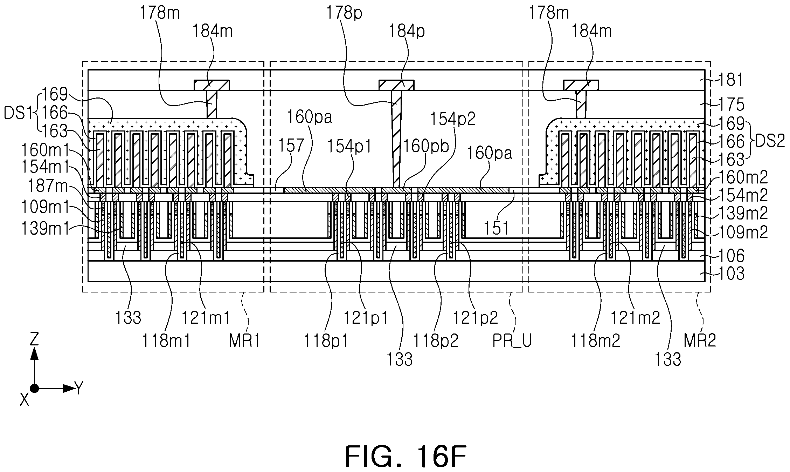

Referring to FIG. 16F, the insulating structure 151 may be formed on the element formed as above, and plugs 154m1, 154p 1, 154p2, and 154m2 penetrating the insulating structure 151 may be formed.

The plugs 154m1, 154p1, 154p2, and 154m2 may include cell plug patterns 154m1, 154m2 connected to the first and second cell upper source/drain regions 187m, and peripheral contact structures 154p1 and 154p2 connected to the upper NMOS source/drain regions 187p1 and the upper PMOS source/drain regions 187p2.

The insulating structure 157 and the conductive patterns 160m1, 160pa, 160pb, and 160m2 may be formed on the insulating structure 151 and the plugs 154m1, 154p1, 154p2, and 154m2. The insulating structure 157 may be formed on side surfaces of the conductive patterns 160m1, 160pa, 160pb, and 160m2.

The conductive patterns 160m1, 160pa, 160pb, and 160m2 may include the cell pad patterns 160m1, 160m2 connected to the cell plug patterns 154m1, 154m2, and the upper peripheral wirings 160pa and 160pb connected to the peripheral contact structures 154p1 and 154p2.

Data storage structures DS1 and DS2 may be formed on the cell plug patterns 154m1 and 154m2. The data storage structures DS1 and DS2 may have first electrodes 163 extending in the vertical direction Z, a second electrode 169 on a side surface and and upper surface of each of the first electrodes 163, and a dielectric layer between the first electrodes 163 and the second electrode 169.

An insulating structure 175 covering the data storage structures DS1 and DS2 may be formed, and contact plugs 178m and 178p penetrating the insulating structure 175 may be formed.

The contact plugs 178m, 178p may include cell contact plugs 178m connected to the second electrodes 169 of the data storage structures DS1 and DS2, and a peripheral contact plug 178p connected to the upper peripheral wiring 160pb of one of the upper peripheral wirings 160pa and 160pb.

Upper wirings 184m and 184p connected to the contact plugs 178m and 178p may be formed on the insulating structure 175, and upper insulating structure 181 covering the upper wirings 184m and 184p may be formed.

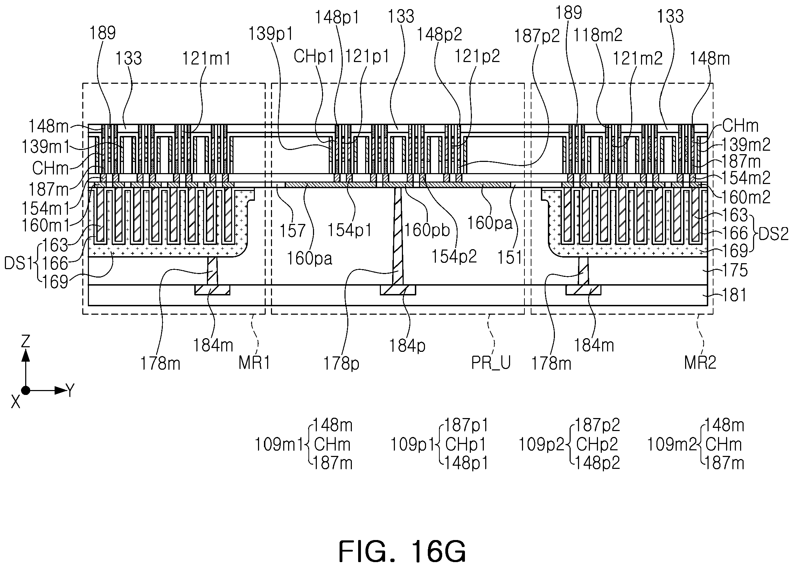

Referring to FIG. 16G, the buffer insulating layer 133, the vertical active patterns 109m1, 109p1, 109p2, and 109m2 and the preliminary back gate electrodes 121 may be exposed by removing the sacrificial substrate 103.

By etching back the preliminary back gate electrodes 121, back gate electrodes 121m1, 121m2, 121p1, and 121p2 may be formed.

The back gate electrodes 121m1, 121m2, 121p1, and 121p2 may include cell back gate electrodes 121m1 and 121m2 in the first and second memory regions MR1 and MR2, and third peripheral gate electrodes 121p1 and 121p2 in the first peripheral circuit region PR_U.

Upper back gate capping insulating layers 189 may be formed on the back gate electrodes 121m1, 121m2, 121p1, and 121p2.

By performing the fourth ion implantation process, lower cell source/drain regions 148m may be formed in lower regions of the first and second cell vertical active patterns 109m1 and 109m2. The lower cell source/drain regions 148m may have N-type conductivity.

Lower NMOS source/drain regions 148p1 may be formed in the lower regions of the NMOS vertical active patterns 109p1 by performing the fifth ion implantation process. The lower NMOS source/drain regions 148p1 may have N-type conductivity.

In an example, the lower NMOS source/drain regions 148p1 may have a doping concentration different from that of the lower cell source/drain regions 148m.

In another example, when the lower NMOS source/drain regions 148p1 has the same doping concentration as the lower cell source/drain regions 148m, the first and second ion implantation processes may be performed as an integrated process.

By performing the sixth ion implantation process, lower PMOS source/drain regions 148p2 may be formed in the lower regions of the PMOS vertical active patterns 109p2. The lower PMOS source/drain regions 148p2 may have P-type conductivity.

Each of the cell vertical active patterns 109m1 may include the lower cell source/drain region 148m, the upper cell source/drain region 187m, and the cell channel region CHm between the lower cell source/drain region 148m and the upper cell source/drain region 187m.

Each of the NMOS vertical active patterns 109p1 may include the lower NMOS source/drain region 148p1, the upper NMOS source/drain region 187p1, and the NMOS channel region CHp1 between the lower NMOS source/drain region 148p1 and the upper NMOS source/drain region 187p1.

Each of the PMOS vertical active patterns 109p2 may include the lower PMOS source/drain region 148p2, the upper PMOS source/drain region 187p2, and the PMOS channel region CHp2 between the lower PMOS source/drain region 148p2 and the upper PMOS source/drain region 187p2.

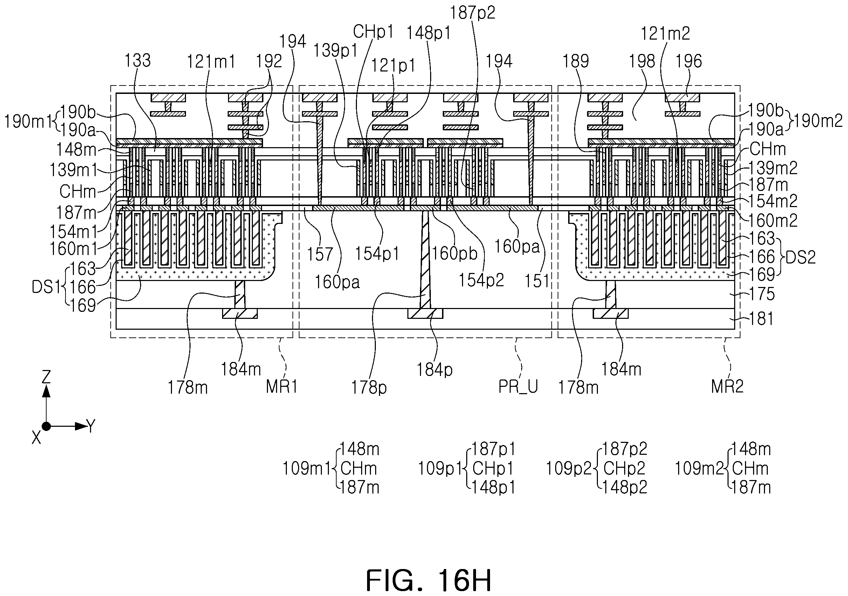

Referring to FIG. 16H, bit lines 190m1 and 190m2 and lower peripheral wirings 190p1 and 190p2 may be formed. Each of the bit lines 190m1 and 190m2 and the lower peripheral wirings 190p1 and 190p2 may include a first conductive layer 190a and a second conductive layer 190b on the first conductive layer 190a.

The bit lines 190m1 and 190m2 may be connected to the cell vertical active patterns 109m1. The lower peripheral wirings 190p1 and 190p2 may be connected to the peripheral vertical active pattern 109p1 and 109p2.

An insulating structure 198, a first routing wiring structure 192, connection contact plugs 194 and first bonding pads 196 may be formed. The first bonding pads 196 may have upper surfaces coplanar with an upper surface of the insulating structure 198.

The first routing wiring structure 192 may include a plurality of wirings disposed on different levels and a plurality of vias connected to an upper surface and a lower surface of each of the plurality of wirings. The lower surfaces of the connection contact plugs 194 may be connected to the first upper peripheral wirings 160pa among the upper peripheral wirings 160pa and 160pb. One of the plurality of wirings disposed on different levels of the first routing wiring structure 192 may be connected to the upper surfaces of the connection contact plugs 194.

Accordingly, the first structure CH1 as in FIGS. 1A and 7 may be formed.

In the description below, referring to FIG. 17, a device isolation region 10s limiting active regions 10a may be formed on the substrate 5. The substrate 5 may be configured as a semiconductor substrate. Lower peripheral circuit transistors 25a, 25b, and 25c may be formed on the substrate 5. Each of the lower peripheral circuit transistors 25a, 25b, and 25c may include peripheral gate structures 15a and 15b disposed on the active region 10a, and peripheral source/drain regions 20sd disposed in the active region 10a disposed on both sides of the peripheral gate structure 15a and 15b. The peripheral gate structures 15a and 15b may include a peripheral gate dielectric layer 15a and a peripheral gate electrode 15b stacked in order.

A second routing wiring structure 30 electrically connected to the lower peripheral circuit transistors 25a, 25b, and 25c, second bonding pads 35 electrically connected to the second routing wiring structure 30 on the second routing wiring structure 30, and a lower insulating structure 40 may be formed on the lower peripheral circuit transistors 25a, 25b, and 25c. The lower insulating structure 40 may have an upper surface coplanar with upper surfaces of the second bonding pads 35. The lower peripheral circuit transistors 25a, 25b, and 25c may include a first core circuit transistor 25a in the first core circuit region CR1, a second core circuit transistor 25b in the second core circuit region CR2, and a second peripheral circuit transistor 25c in the second peripheral circuit region PR_L. Accordingly, the second structure CH2 as in FIG. 1A may be formed.

Referring to FIG. 1A along with FIGS. 16H and 17, the first structure CH1 and the second structure CH2 may be bonded to each other by performing a wafer bonding process. Upper surfaces of the second bonding pads 35 may be bonded to lower surfaces of the first bonding pads 196, and upper surfaces of the lower insulating structure 40 may be bonded to lower surfaces of the first insulating structure 198. Accordingly, a bonding surface JSa may be formed between the first structure CH1 and the second structure CH2.

According to the aforementioned example embodiments, transistors including vertical active patterns extending in the vertical direction and gate electrodes facing the side surfaces of the vertical active patterns may be provided. Accordingly, integration density of a semiconductor device may increase.

Also, to increase integration density of the semiconductor device, a first peripheral circuit region may be provided on an outside of the memory region, and a core circuit region may be provided in a region vertically overlapping the memory region.

Also, to increase integration density of the semiconductor device, a second peripheral circuit region vertically overlapping the first peripheral circuit region may be provided.

While the example embodiments have been illustrated and described above, it will be configured as apparent to those skilled in the art that modifications and variations may be made without departing from the scope in the example embodiment as defined by the appended claims.

## Claims

1. A semiconductor device, comprising:
a first structure including a memory region and a first peripheral circuit region; and
a second structure vertically overlapping the first structure and including a core circuit region and a second peripheral circuit region,
wherein the memory region includes:
a first cell vertical active pattern;
a first word line having a side surface facing a first side surface of the first cell vertical active pattern; and
a first cell gate dielectric layer between the first cell vertical active pattern and the first word line,
wherein the first peripheral circuit region includes:
a first peripheral vertical active pattern disposed at substantially the same level as the first cell vertical active pattern;
a first peripheral gate electrode having a side surface facing a first side surface of the first peripheral vertical active pattern; and
a first peripheral gate dielectric layer between the first peripheral vertical active pattern and the first peripheral gate electrode.

2. The semiconductor device of claim 1,
wherein the memory region further includes a data storage structure,
wherein the core circuit region includes a core circuit transistor vertically overlapping the memory region, and
wherein the second peripheral circuit region includes a peripheral circuit transistor not vertically overlapping the memory region.

3. The semiconductor device of claim 2, wherein the first peripheral circuit region further includes a power capacitor disposed at substantially the same level as the data storage structure.

4. The semiconductor device of any preceding claim, wherein the first cell vertical active pattern includes:
a lower cell source/drain region;
an upper cell source/drain region on the lower cell source/drain region; and
a cell channel region between the lower cell source/drain region and the upper cell source/drain region,
wherein the first peripheral vertical active pattern includes:
a lower peripheral source/drain region;
an upper peripheral source/drain region on the lower peripheral source/drain region; and
a peripheral channel region between the lower peripheral source/drain region and the upper peripheral source/drain region,
wherein the side surface of the first word line faces the cell channel region of the first cell vertical active pattern, and
wherein the side surface of the first peripheral gate electrode faces the peripheral channel region of the first peripheral vertical active pattern.

5. The semiconductor device of any preceding claim,
wherein the memory region further includes:
a bit line below the first cell vertical active pattern;
a cell contact structure on the first cell vertical active pattern; and
a data storage structure on the cell contact structure,
wherein the first peripheral circuit region further includes:
a first peripheral wiring below the first peripheral vertical active pattern;
a peripheral contact structure on the first peripheral vertical active pattern; and
a second peripheral wiring on the peripheral contact structure, and
wherein the first peripheral wiring is disposed at substantially the same level as the bit line.

6. The semiconductor device of claim 5,
wherein the cell contact structure includes:
a cell plug pattern on the first cell vertical active pattern; and
a cell pad pattern on the cell plug pattern,
wherein the peripheral contact structure is disposed at substantially the same level as the cell plug pattern, and
wherein the second peripheral wiring is disposed at substantially the same level as the cell pad pattern.

7. The semiconductor device of claim 5 or claim 6,
wherein the data storage structure includes:
a first electrode extending in a vertical direction and on the cell contact structure;
a second electrode on the first electrode; and
a dielectric layer between the first electrode and the second electrode.

8. The semiconductor device of claim 7, wherein at least a portion of the second peripheral wiring is disposed at the same level as a portion of the second electrode.

9. The semiconductor device of any preceding claim, wherein a vertical length of the first peripheral gate electrode is substantially the same as a vertical length of the first word line.

10. The semiconductor device of any preceding claim,
wherein the first peripheral circuit region further includes:
a second peripheral vertical active pattern disposed at substantially the same level as the first cell vertical active pattern;
a second peripheral gate electrode having a side surface facing a first side surface of the second peripheral vertical active pattern; and
a second peripheral gate dielectric layer between the second peripheral vertical active pattern and the second peripheral gate electrode.

11. The semiconductor device of claim 10, wherein a vertical length of the second peripheral gate electrode is different from a vertical length of the first word line.

12. The semiconductor device of any preceding claim, wherein a thickness of the first peripheral gate dielectric layer is different from a thickness of the first cell gate dielectric layer.

13. The semiconductor device of any preceding claim,
wherein the memory region further includes:
a second cell vertical active pattern adjacent to the first cell vertical active pattern, the first cell vertical active pattern and the second cell vertical active pattern being spaced apart from each other;
a second word line having a side surface facing a second side surface of the second cell vertical active pattern;
a second cell gate dielectric layer between the second cell vertical active pattern and the second word line; and
a cell back gate electrode disposed between the first cell vertical active pattern and the second cell vertical active pattern, and
wherein the first and second cell vertical active patterns are disposed between the first word line and the second word line.

14. The semiconductor device of any preceding claim,
wherein the first peripheral circuit region further includes:
a second peripheral vertical active pattern adjacent to the first peripheral vertical active pattern, the first peripheral vertical active pattern and the second peripheral vertical active pattern being spaced apart from each other;
a second peripheral gate electrode having a side surface facing a second side surface of the second peripheral vertical active pattern;
a second peripheral gate dielectric layer between the second peripheral vertical active pattern and the second peripheral gate electrode; and
a peripheral back gate electrode disposed between the first peripheral vertical active pattern and the second peripheral vertical active pattern, and
wherein the first and second peripheral vertical active patterns are disposed between the first peripheral gate electrode and the second peripheral gate electrode.

15. The semiconductor device of any preceding claim, wherein the second peripheral circuit region vertically overlaps the first peripheral circuit region.
